(19)

**Europäisches Patentamt**
**European Patent Office**
**Office européen des brevets**

(11)  **EP 4 783 170 A1**

(12)  **EUROPEAN PATENT APPLICATION**

(43) Date of publication:
**29.07.2026 Bulletin 2026/31**

(51) International Patent Classification (IPC):
**G11C 11/56** (2006.01)  **G11C 16/26** (2006.01)
**G11C 16/34** (2006.01)  **G11C 29/02** (2006.01)
**G11C 16/04** (2006.01)

(21) Application number: **26152687.5**

(22) Date of filing: **19.01.2026**

(52) Cooperative Patent Classification (CPC):
**G11C 29/028; G11C 11/5642; G11C 16/26;**
**G11C 16/3404;** G11C 16/0483

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **27.01.2025 US 202519038539**

(71) Applicant: **Kioxia Corporation**
**Tokyo (JP)**

(72) Inventors:
• **Steiner, Avi**
**69719 Tel Aviv (IL)**

• **Kanter, Ofir**
**69719 Tel Aviv (IL)**
• **Nahisi, Zion**
**69719 Tel Aviv (IL)**
• **Weingarten, Hanan**
**69719 Tel Aviv (IL)**
• **Kurosawa, Yasuhiko**
**Minato-ku, Tokyo (JP)**
• **Ushijima, Yasuyuki**
**Minato-ku, Tokyo (JP)**

(74) Representative: **Hoffmann Eitle**
**Patent- und Rechtsanwälte PartmbB**
**Arabellastraße 30**
**81925 München (DE)**

(54) **SYSTEMS AND METHODS FOR HIGH PERFORMANCE READ WITH FUTURE VOLTAGE THRESHOLD ESTIMATION IN NVM**

(57)      The present disclosure relates to a flash memory system including a non-volatile memory and a circuit for performing operations on the non-volatile memory. The circuit may determine, by a machine learning model at a first time point, a plurality of voltage thresholds for read operations on the non-volatile memory, based on one or more stress conditions at the first time point. The plurality of voltage thresholds may correspond to respective time durations since the first time point. The circuit may obtain, from the plurality of voltage thresholds, one or more voltage thresholds associated with a particular time duration of the respective time durations. The circuit may perform, at a second time point that is later than the first time point by the particular time duration, a read operation on the non-volatile memory with the one or more voltage thresholds associated with the particular time duration.

202 — First Phase Read

204 — Decode HB

206 — Retry −fixed Thresholds Table + HB Decode

208 — Quick Threshold Tracking

210 — Decode HB

212 — Tracking Vth

214 — Sampling + Soft Decoding

200

**FIG. 2**

**Description**

TECHNICAL FIELD

The present arrangements relate generally to system and method for performing operations of a flash memory, and more particularly to system and method for estimating voltage thresholds for use at a later time based on current voltage threshold distributions and/or current stress conditions.

BACKGROUND

As the number and types of computing devices continue to expand, so does the demand for memory used by such devices. Memory includes volatile memory (e.g. RAM) and non-volatile memory. One popular type of non-volatile memory is flash memory or NAND-type flash. A NAND flash memory array includes rows and columns (strings) of cells. A cell may include a transistor.

Due to different stress conditions (e.g., NAND noise and interference sources) during programming and/or read of the NAND flash memory, there may be errors in the programmed and read output. Improvements in decoding capabilities in such a wide span of stress conditions for NAND flash devices remain desired.

SUMMARY

The present arrangements relate to system and method for estimating voltage thresholds for use at a later time based on current voltage threshold distributions or current stress conditions.

According to certain aspects, arrangements provide a method for performing operations on a non-volatile memory. The method may include determining, by a machine learning model at a first time point, a plurality of voltage thresholds for read operations on the non-volatile memory, based on one or more stress conditions at the first time point, wherein the plurality of voltage thresholds correspond to respective time durations since the first time point. The method may include obtaining, from the plurality of voltage thresholds, one or more voltage thresholds associated with a particular time duration of the respective time durations. The method may include performing, at a second time point that is later than the first time point by the particular time duration, a read operation on the non-volatile memory with the one or more voltage thresholds associated with the particular time duration.

According to other aspects, arrangements provide a flash memory system including a non-volatile memory and a circuit for performing operations on the non-volatile memory. The circuit may be configured to determine, by a machine learning model at a first time point, a plurality of voltage thresholds for read operations on the non-volatile memory, based on one or more stress conditions at the first time point. The plurality of voltage thresholds may correspond to respective time durations since the first time point. The circuit may be configured to obtain, from the plurality of voltage thresholds, one or more voltage thresholds associated with a particular time duration of the respective time durations. The circuit may be configured to perform, at a second time point that is later than the first time point by the particular time duration, a read operation on the non-volatile memory with the one or more voltage thresholds associated with the particular time duration.

BRIEF DESCRIPTION OF THE DRAWINGS

These and other aspects and features of the present arrangements will become apparent to those ordinarily skilled in the art upon review of the following description of specific arrangements in conjunction with the accompanying figures, wherein:

FIG. 1 illustrates an example of a voltage threshold distribution according to some arrangements;

FIG. 2 illustrates an example process of read flow in a conventional flash device;

FIG. 3 illustrates an example of a fully-connected (FC) deep neural network (DNN) for a row-to-row (R2R) estimator according to some arrangements;

FIG. 4A illustrates an example of read flow according to some arrangements;

FIG. 4B illustrates an example of database mapping for training thresholds estimation/tracking, according to some arrangements;

FIG. 5A illustrates an example of read flow including future predictive (FP) thresholds estimation, according to some arrangements;

FIG. 5B illustrates an example of database mapping for training FP thresholds estimation/tracking, according to some arrangements;

FIG. 6 is a flowchart illustrating an example methodology for generating a training database for FP thresholds estimation, according to some arrangements;

FIG. 7A and FIG. 7B illustrate an example of selecting future optimal thresholds mapping to future stress cases, according to some arrangements;

FIG. 8 is a flowchart illustrating another example methodology for generating a training database for training for FP thresholds estimation, according to some arrangements;

FIG. 9 is a flowchart illustrating an example methodology for performing a patrol read, according to some arrangements;

FIG. 10 is a flowchart illustrating another example methodology for performing a patrol read, according to some arrangements, according to some arrangements;

FIG. 11 illustrates a diagram illustrating example results of fail bit counts (FBC) for evaluating patrol reads using future predictive quick training (FPQT), according to some arrangements;

FIG. 12 is a flowchart illustrating an example methodology for a generic estimator of FP thresholds, according to some arrangements;

FIG. 13 is a flowchart illustrating another example methodology for dynamic inter-cell-interference (ICI) FP thresholds estimation, according to some arrangements;

FIG. 14 is a block diagram illustrating an example flash memory system according to some arrangements; and

FIG. 15 is a flowchart illustrating an example methodology for estimating voltage thresholds for use at a later time based on current voltage threshold distributions and/or current stress conditions, according to some arrangements.

DETAILED DESCRIPTION

According to certain aspects, arrangements in the present disclosure relate to techniques for estimating voltage thresholds for use at a later time based on current voltage threshold distributions and/or current stress conditions.

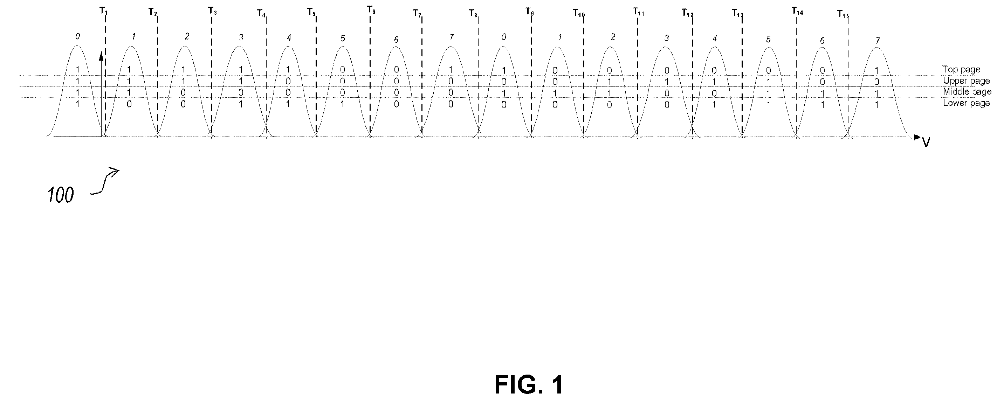

FIG. 1 illustrates an example of a voltage threshold distribution 100 according to some arrangements. FIG. 1 illustrates a voltage threshold distribution of a 4 bits per cell (bpc) flash memory device, i.e., quadruple level cells (QLC) with 16 programmable states. The voltage threshold (VT) distribution includes 16 lobes. A lower page read requires using thresholds T1, T3, T6 and T12. For reading the middle page, the read thresholds T2, T8, T11 and T13 are used. For reading the upper page, the read thresholds T4, T10 and T14 are used. For reading the top page, thresholds T5, T7, T9 and T15 are used. The lower most lobe (0) is known as the erase level. Retention, program/erase cycles and read disturb can change the voltage threshold distribution (e.g., voltage threshold distribution shown in FIG. 1) in different ways and create various bit error rate (BER) conditions. For each condition, different read thresholds can be chosen for achieving lowest BER after READ operation. Thus, the read thresholds of a target page in a NAND device are estimated repeatedly during the device life cycle in order to maintain high read performance and benefit from an efficient read flow with low latency that avoids SB decoding (soft-bit decoding) as much as possible.

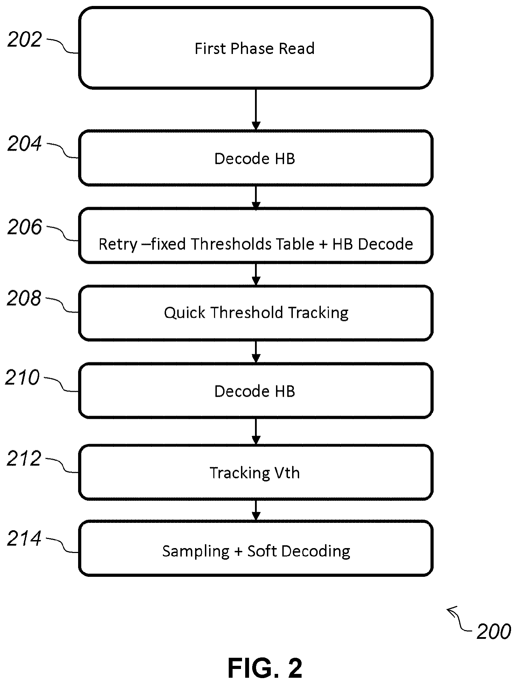

FIG. 2 illustrates an example (simplified) process 200 of read flow in a conventional flash device. FIG. 2 describes typical stages for read-retry in case of failures. On default, a flash memory system (e.g., a controller, a read circuit or an error correction code (ECC) decoder of a NAND flash device) may perform first-phase reads, which refers to reads with preconfigured (or pre-defined) initial default thresholds (step 202). The system (e.g., a controller of a NAND flash device) may decode a read by a hard-bit (HB) decoder, e.g., a decoder that operates on binary input (step 204). In case of a decode failure, the controller may refer to a shift table that holds several thresholds candidates. The candidate thresholds are also referred to as a "retry-fixed thresholds table". On a first (read) failure on a page, the controller may choose or select a first table entry, configure the NAND thresholds based on the first entry, read the same page again, and perform HB decoding (step 206). In case of a second failure, the process may be repeated with other shift table candidates until success on HB decoding. On a HB decode success, the shift table entry (e.g., a threshold candidate used for the read corresponding to the HB decode success) may be saved in a table called history table (HT) that is available per block. A pointer to the HT may be used for future reoccurring reads from same block, to allow the controller to use the same thresholds that are compatible to a current stress of this block. If decoding fails with all shift table candidates, then the controller may perform a quick threshold tracking (QT) to estimate the optimal thresholds of the current row (step 208). The QT may perform a few mock reads with fixed thresholds, from which a histogram is computed. An estimator (e.g., controller, or software, firmware, hardware, or a combination thereof) may use the histogram for estimating the current thresholds. The estimator can be a linear estimator or a DNN based estimator. The controller may configure estimated thresholds to NAND, and perform a read-retry, followed by HB decoding (step 210). If HB decoding fails, then the controller may perform a higher complexity threshold tracking (step 212), e.g., pre-soft tracking (PST), followed by sampling and/or soft decoding (step 214).

In some arrangements of the present disclosure, a system (e.g., a NAND flash device or a controller thereof) can perform a row-to-row (R2R) estimation. According to the physical characteristics of the NAND, there is a typical voltage-threshold (VT) probability distribution for every NAND row per block. On 3D-NANDs there may be a typical distribution per word-line (WL), where rows within a given WL may have a similar VT distribution (referred to as a row-VT distribution). Therefore, if thresholds are known for a target row as a result of activating an estimation process on that row, then it might be useful to use this result and estimate thresholds of any other row, from a given row (e.g., the target row) and thresholds of the given row, by using the typical row-VT distribution, thereby saving the cost and/or overhead of thresholds-estimation per row.

According to some arrangements of the present disclosure, a row-to-row (R2R) estimator can be trained in order to provide a minimized retry probability, when a controller performs first-phase reads. The R2R estimator can receive as input a target row, and provide optimal shifts (e.g., optimal in terms of reducing a retry probability) to apply with respect to a first-phase read shift. In some arrangements, the first-phase read shift may be zero shifts of default thresholds. The R2R estimator can be implemented in various manners including (1) a look-up-table (LUT), which provides the shifts per threshold and per row; (2) a linear based estimator; and/or (3) a deep neural network (DNN) based estimator. In some arrangements, a LUT-based R2R estimator for first-phase reads may be fully optimized to support all required stresses to provide lowest read-retry rate (RRR) with first-phase-reads using a LUT (e.g., a LUT which provides the shifts per threshold and per row). As a NAND density increases, the blocks may become larger, due to having more layers and strings per block. The advantage of using a DNN-based R2R estimator is relatively smaller memory requirements for such large blocks. Thus, a DNN-based R2R estimator can perform effectively a compression of a LUT. Such DNN-based compression is also scalable to future NAND devices.

In some arrangements, an R2R estimator can be trained for a fixed thresholds set, which are used within a read retry flow (or a read retry process/operation). That is, the R2R estimator can have a specific trained configuration for every entry of a retry-fixed thresholds table, where each entry represents another subset of stress conditions that are supported by the controller. For example, in case of data-retention (DR) stress, thresholds can be optimized over a specific row that is referred to as "reference row". A table (e.g., LUT for R2R) can be optimized on this stress as well, to convert the reference row thresholds to every other row under this DR stress.

In some arrangements, the R2R estimator can be described as:

$$TH_{r2r}(row, ShiftIdx) = TH_{ref}(ShiftIdx) + LUT_{ShiftIdx}(row) \ldots\ldots\ldots\ldots (\text{Equation 1})$$

For every shift index, a LUT can be defined per row to provide target thresholds. A shift index may be a retry-fixed thresholds table index which is an index to a retry-fixed thresholds table. An "index" or "shift index" refers to a retry pointer that is saved per block. The retry pointer can be associated with a stress condition. Holding a LUT per shift-index means that there is a different R2R estimator per read-retry. The row index can be an entry pointer to the LUT. This can adapt the R2R estimation according to a stress condition. In some arrangements, first-phase reads may correspond to ShiftIdx=0. This LUT-based implementation may be memory inefficient. In a LUT implementation, a suboptimal solution which saves memory can use a common LUT for all shift indexes, as follows:

$$TH_{r2r}(row, ShiftIdx) = TH_{ref}(ShiftIdx) + LUT(row) \ldots\ldots\ldots\ldots (\text{Equation 2})$$

where an identical LUT can be used for all shift indices. The LUT can also be the same table for the case of read after quick threshold tracking (QT). The reference thresholds in the case of read after QT may be mapped from a failed row to a (common) reference row using the LUT, and then the thresholds value may be compressed by clustering to the nearest cluster (e.g., using K-means clustering), and only the index cluster center can be saved as the ShiftIdx. This compression can significantly reduce the memory requirements per threshold tracking operation, allow for using a compact history table (HT) to save the state of a block after failure, and/or allow near optimal thresholds for all rows using the R2R estimator with the mapped ShiftIdx after QT.

In some arrangements, the R2R estimator can be implemented by a DNN, which may receive the ShiftIdx as an input feature, together with a row index (e.g., row index of a target row), and provide the thresholds to be used for read of the target row. The ShiftIdx can be available from the history table per block.

$$TH_{r2r}(row) = DNN(ShiftIdx, row) \dots\dots\dots\dots \text{(Equation 3)}$$

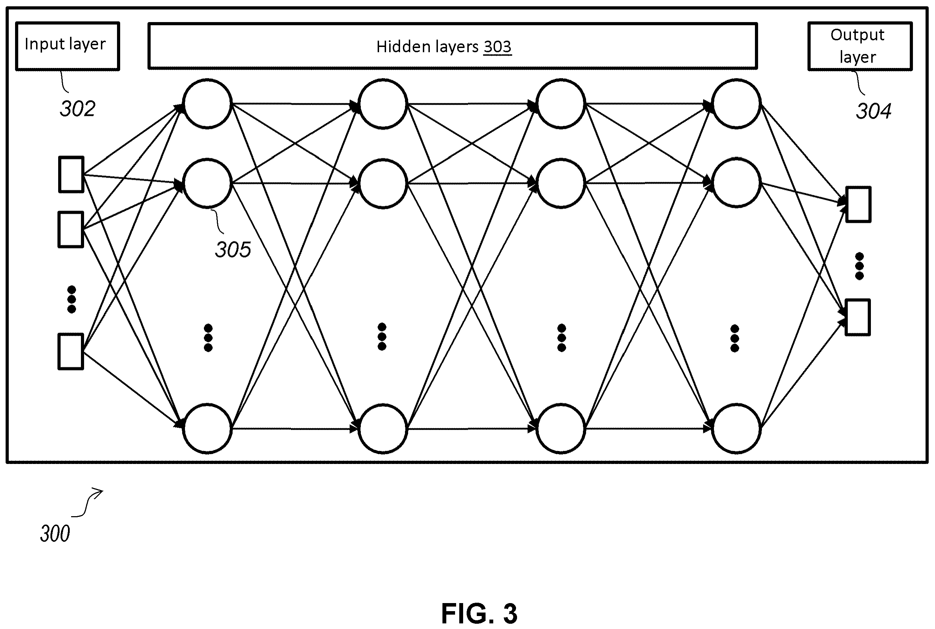

FIG. 3 illustrates an example of a fully-connected (FC) deep neural network (DNN) 300 for a row-to-row (R2R) estimator according to some arrangements. The example DNN may include an input layer 302, one or more hidden layers 303, and/or an output layer 304. In the example DNN shown in FIG. 3, the input layer 302 can include a target row index (e.g., index to a target row) and a shift index. The output layer 304 can include an estimated thresholds for the target row.

In some arrangements of the present disclosure, a row index can be represented by entity embedding (EE) which is a result of a 1-hot input training for a DNN estimator (e.g., DNN-based R2R estimator). In some arrangements, entity embedding for the row index can be implemented or obtained by training a 1-hot input of row index that is fully connected to a few neurons of a DNN (e.g., neurons 305). The entity embedding values per row can be saved in a LUT which is used as input instead of a 1-hot input. For example, the LUT can map a row index to values of neurons that are connected to the original 1-hot input. The LUT can be used to provide the neuron values per row index instead of the 1-hot input and the neuron's fully connect weights. This can save a lot of memory, and can reduce implementation complexity. This LUT-based implementation of the entity embedding (EE) is very robust for large NAND blocks with many rows. Since the entity embedding (EE) implementation saves memory and reduces implementation complexity, the EE can be used for large NAND blocks. The EE can be an alternative form for implementing row index encoding to neuron values.

In some arrangements, a DNN (or a DNN-based R2R estimator) can be trained with input thresholds which correspond to (1) optimal thresholds of a selected reference row, or (2) QT thresholds of the selected reference row. In some arrangements, the R2R thresholds obtained by the DNN-based R2R estimator can be given by

$$TH_{r2r}(row) = DNN(ShiftIdx, row, TH_{HT-ref}) \dots\dots\dots\dots \text{(Equation 4)}$$

where the ShiftIdx (shift index) can be a pointer to the phase/retry stages of the history table. The shift index can correspond to the number of retry or the current stress condition (e.g., retry index). This retry index can be a subset of a history table (HT). The HT can be a generalized form of saving thresholds per block corresponding to different stress conditions. The ShiftIdx can be a pointer to the generalized HT. Initial few entries (e.g., low index values) of the HT can correspond to a few ordered start-of-life (SOL) set of stresses, hence the shift-index can be used as input to the DNN. The $TH_{HT-ref}$ input can correspond to the thresholds extracted from the history table, in case that QT is activated on this block. The $TH_{HT-ref}$ input can be reference thresholds from HT that are closest to the estimated thresholds by a QT operation while $TH_{HT-ref}$ is read-flow dependent.

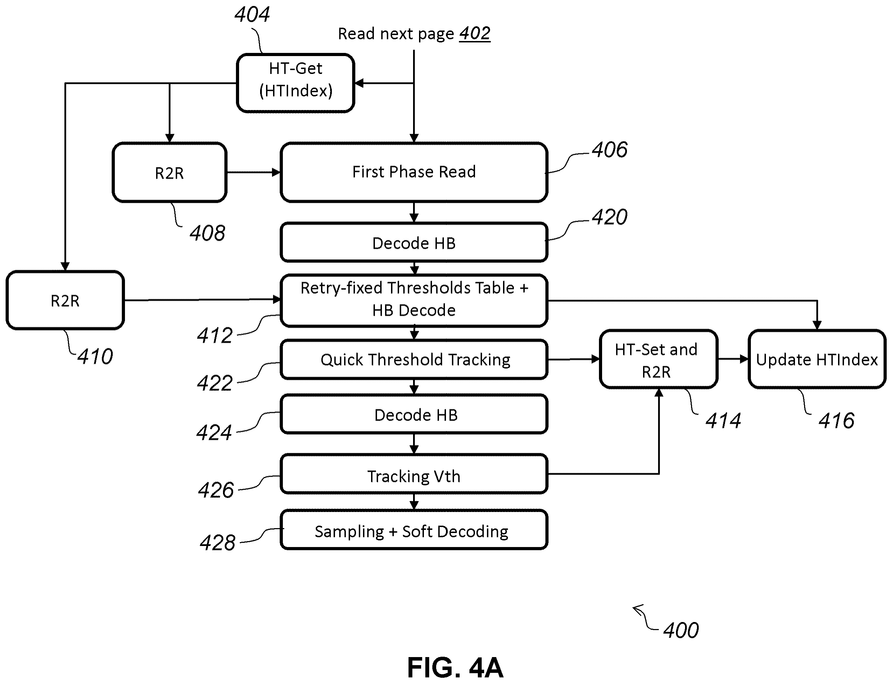

FIG. 4A illustrates an example process 400 of read flow that employs an R2R estimator for all stages in the read flow according to some arrangements. FIG. 4A demonstrates a read-flow which employs a R2R transformation on input thresholds, according to a read stage. The R2R thresholds can be taken or obtained from a R2R estimator according to some arrangements of the present disclosure.

In some arrangements, the read flow shown in FIG. 4A includes receiving and/or executing a read command to a target page (step 402). A history table (HT)-Get operation can extract a HTIndex (e.g., index to a history table) that keeps the state of the block and points to the type of read on a first stage (e.g., first phase read) (step 404). For example, if HTIndex is equal to 0, then first-phase reads can be performed with read thresholds according to a row of a target page (step 406). For example, when using a DNN-based R2R estimator (step 408), for HTIndex=0, the read thresholds can be $DNN(0, row)$ (see Equation 3) which corresponds to a DNN output. If HTIndex has another value that is up to (or less than or equal to) the number of entries in retry-fixed thresholds table (step 410), then $DNN(HTIndex, row)$ (see Equation 3) can be used to provide the read thresholds (step 412). If (or only if) HTIndex is higher than the number of retry-fixed thresholds-table entries, then HTIndex can refer to a codebook that provides the corresponding thresholds, which are extracted from a LUT. The LUT is a codebook such that the input of the LUT is the HTindex (same as shiftidx), and the output of the LUT are thresholds for reference row ($TH_{HT-ref}$). An R2R estimator can provide the target row thresholds using $DNN(ShiftIdx, row, TH_{HT-ref})$ (see Equation 4). Steps 420, 422, 424, 426, 428 can be similar to steps 204, 208, 219, 212, 214 as shown in FIG. 2, respectively. After performing quick threshold tracking (QT), an HTIndex can be computed using the HT-Set operation (step 414), which can be implemented by a K-means search algorithm, and the HTIndex can be updated (step 416).

In some arrangements, for the read-flow shown in FIG. 4A, the R2R estimator can be either an identical estimator for all HT indices by providing as input the thresholds for each of the stages. Alternatively, the R2R estimator can be optimized per HTIndex separately. The implementation type may depend on implementation complexity limitations, and estimation-accuracy tradeoffs.

In some arrangements, when performing HT-Set operation (step 414) after QT (step 422), the system can transform the estimated thresholds of a target row to a common reference row, that is then compressed by assigning the closest thresholds of HT table, and saving the HTIndex. The R2R estimator from a given row to a reference row can be a linear estimator of the form as follows:

$$TH_{HT-ref}(est) = TH_{est}(row) - LUT(row) \ldots\ldots\ldots\ldots (\text{Equation 5})$$

where the $TH_{HT-ref}(est)$ refers to estimated thresholds of the reference row, the $TH_{est}(row)$ refers to estimated thresholds of the target row, and $LUT(row)$ refers to shifts per threshold corresponding to the target row.

In some arrangements, the system can estimate thresholds of the reference row with a DNN as follows:

$$TH_{HT-ref}(est) = DNN(row, TH_{est}(row)) \ldots\ldots\ldots\ldots (\text{Equation 6})$$

In some arrangements, the system can perform HT-Set to obtain and save the HTindex closest to $TH_{HT-ref}(est)$ for this block which includes a plurality of rows.

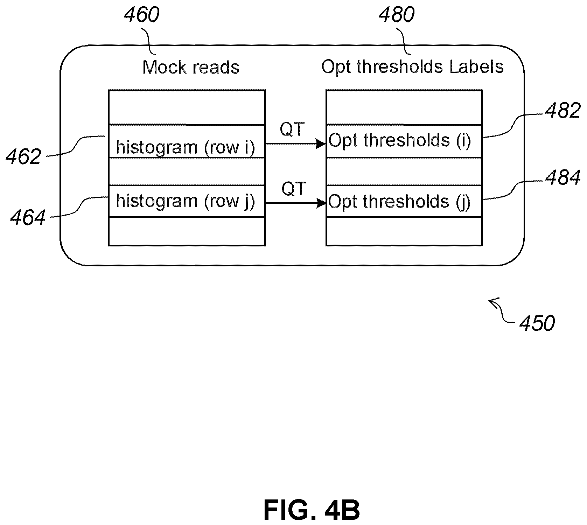

FIG. 4B illustrates an example of database mapping for training thresholds estimation/tracking, according to some arrangements. In some arrangements, DNN-based estimators (e.g., DNN-based R2R estimators) can use a database 450 storing optimal thresholds 480 that serve as labels in training. The rows (e.g., rows 462, 464 representing respective histograms) in the database can be taken from mock-thresholds read (e.g., during QT in step 422) of VT-distributions of many stress conditions. In some arrangements, the optimal thresholds 482, 484 can be computed from these VT-distributions (e.g., histograms 462, 464), respectively.

In one aspect, in a conventional flash memory system (e.g., controller in NAND flash devices), voltage threshold (VT) estimation usually aims to find optimal read thresholds for a given state, to enable the successful subsequent read. However, the VT estimation does not take into consideration that optimal thresholds may be irrelevant after some time (e.g., due to developing data retention, read disturb, etc.). Especially, when performing patrol reads (e.g., scanning the entire NAND flash memory periodically to identify and resolve potential errors before they can cause data corruption or drive failure), as the read thresholds previously estimated become irrelevant, the patrol frequency may need to be increased and as a result the available read bandwidth may be decreased.

To solve these problems, according to certain aspects, arrangements in the present disclosure relate to systems and methods for improving performance of read operations with a future voltage threshold estimation for a NAND flash memory storage. In some arrangements, a flash memory system can achieve high read performance from NAND flash devices following voltage threshold (VT) estimation. The VT estimation can be targeted future compatible read thresholds, which can be optimal for later in time for a developing stress (e.g., read disturb, data retention loss, temperature variations, mechanical stress, or error rate stress, etc.). In some arrangements, the system can estimate thresholds which can be used for longest duration under typical stress conditions thereby maximizing the duration between failures and significantly reducing the frequency of patrol reads. As a result, the probability of retry can be reduced and the available read bandwidth can be increased.

In some arrangements, the system can perform NAND stress conditions characterization, and estimation of target future thresholds for evolving stresses, under present and/or future bit-error-rates (BER) constraints. The system can train a machine learning model (e.g., DNN) or a linear model (e.g., linear "quick-threshold tracking") using mock reads (e.g., mock reads performed during a quick threshold tracking (QT) process) for future VT estimation. In some arrangements, the system can perform quick threshold tracking (QT) to estimate optimal thresholds of a current row (or "current thresholds"). The QT can perform a few mock reads with fixed thresholds, from which a histogram is computed. The histogram can be used (by an estimator) for estimating the current thresholds. The estimator can be a linear estimator, e.g., linear QT, or a DNN based estimator, which is a non-linear QT estimator. The system can use future VT estimation during a read retry in case of an HB decode failure (e.g., step 412 in FIG. 4A).

In some arrangements, the system can use a training model (e.g., design of database that can be used in training a machine learning model) that is determined according to optimal thresholds of future stress applied on current target stress, thereby creating a robust training model. In some arrangements, in generating a training model (e.g., database for training a machine learning model), the system can use an augmentation model to generate intermediate stress VT data, and determine future stress mapping according to BER distribution per cycle count.

In some arrangements, the system can train two types of estimators: (1) a present-optimal VT estimator; and/or (2) a future-optimal VT estimator. In some arrangements, during a read-retry (e.g., step 412 in FIG. 4A), the system can perform mock reads (e.g., step 422 in FIG. 4A) and compute thresholds with (1) the present-optimal VT estimator to be used for a target row read. The system can compute thresholds with (2) the future-optimal VT estimator from the same mock reads, and save resulting thresholds in history table (e.g., HT) for usage on any upcoming, future, later read from the block. In some arrangements, the system can use or train a single estimator (e.g., single DNN estimator) which outputs both (1) present-optimal thresholds and (2) future-optimal thresholds.

In some arrangements, the system can perform a dynamic inter-cell-interference (ICI) compensation estimation with future VT estimation. The ICI refers to the interference that occurs between adjacent memory cells during read and write operations. This interference can cause errors in the stored data, which can degrade the performance and reliability of the flash memory. In some arrangements, the system can estimate thresholds that support, consider or take into account a future data retention (DR) ICI effect (e.g., stronger interference, and higher retention effect), and enable a longer duration of effective ICI compensation without retries.

In some arrangements, the system can calculate, compute or perform a future VT estimation from an arbitrary input histogram of a target page and/or a target row. For example, the system can use an estimator (e.g., DNN-based estimator) that estimates VT thresholds from a generic histogram obtained from current and/or recent reads and if needed additional predefined mock thresholds. The arbitrary/generic input histogram may be at least one of various types of histograms. For example, a histogram can be computed from multiple page reads of a target row with the thresholds that were intended for the read itself (e.g., dedicated reads of the target row). In some arrangements, a histogram can be computed from retries of multiple page reads of a target row. In some arrangements, a histogram can be computed from a tracking process (e.g., mock reads during a QT process). The histogram computed can be fed to a DNN estimator along with information on the read thresholds, and the DNN estimator can perform estimation of current or future thresholds. Mock thresholds (e.g., thresholds for mock reads) can be considered as predetermined thresholds which can be used for dedicated reads needed only for achieving accurate estimation. In some arrangements, the system can use both read page results (e.g., results of dedicated reads) and mock reads results for histogram computation.

In some arrangements, in case of HB decoding failure (e.g., step 420) on normal read (e.g., step 406) and all shift-table read retries (e.g., step 412), the system can perform a future predictive (FP) threshold estimation (also referred to as "future quick threshold training or tracking (FPQT)") which can estimate future predictive (FP) thresholds, as well as current optimal thresholds.

In some arrangements, the system (e.g., controllers of a flash memory system) can perform FPQT as typical stages for read-retry in case of failures. In response to determining decoding fails with all shift-table candidates, the system can perform FPQT to estimate optimal thresholds of the current row. In some arrangements, the system can perform FPQT by performing a few mock reads with fixed thresholds, from which a histogram is computed. The system can use one or more estimators with the histogram for estimating both current thresholds and FP thresholds. The one or more estimators can include a linear estimator and/or a machine learning-based (e.g., DNN-based) estimator. The system can configure NAND with the current estimated thresholds for a retry read and HB decode. The system can use an R2R operation (LUT-based R2R or DNN-based R2R) to transfer or convert the FP thresholds to reference row FP thresholds, and use these reference row FP thresholds for updating the HT table (HT-Set operation). The system can perform HT-Set by compressing the estimated FP thresholds (e.g., reference row FP thresholds) into an index pointer HTindex for the HT table. The HTindex can point to HT thresholds that are closest to the estimated FP thresholds, and can be used for subsequent reads from the same block.

In some arrangements, the system can estimate only FP thresholds that are to be used after FPQT for HB decode and for HT-Set. This can save an estimation process, and provide sufficient reliability, which is guaranteed during the training of the estimator.

In some arrangements, the system can train FP thresholds estimators (also referred to as "FPQT estimators"; e.g., DNN-based FPQT estimators) using a database (as training data) storing histograms and optimal thresholds at respective rows (e.g., rows m, i, j, k). For example, the database can store histogram (m), histogram (i), histogram (j) at rows m, i, and j, respectively, and store optimal thresholds (m), optimal thresholds (j), optimal thresholds (k) at rows m, j, and k, respectively. The histograms can be taken from mock-thresholds reads (e.g., during FPQT) of VT-distributions of many stress conditions. The optimal thresholds can serve as labels in training.

In some arrangements, the system can train a future predictive quick training (FPQT) estimator like the regular estimator that predicts current thresholds. In some arrangements, in order to predict future thresholds, the database can be organized in a particular order which enables mapping between a specific input mock-histogram row and a label of target thresholds that is optimal at a later time, or in a later stress. In this manner, for some typical distributions the estimated thresholds can correspond to future optimal thresholds, and for other typical distributions, the estimated thresholds can correspond to current optimal values. Here, "future optimal thresholds" refers to optimal thresholds derived from additional stress conditions (or from a database storing additional stress conditions). Examples of the "additional stress conditions" may include (1) longer equivalent retention conditions (or a database thereof) for data retention stress, and/or (2) more read operations (or a database thereof) for read disturb stress.

In some arrangements, some rows which correspond to stresses with future relevant thresholds can be mapped to labels that provide a good prediction of optimal thresholds as the stress evolves. In some arrangements, horizontal connections (between the same stress condition) can connect current optimal thresholds mapping, and diagonal connections (between different stress conditions) can connect rows that are mapped to future optimal thresholds. For example, a histogram in a particular row (e.g., histogram (m)) can be mapped to the current optimal thresholds (e.g.,

optimal threshold (m)). A histogram in a particular row can be mapped to future optimal thresholds in a different row. For example, the histogram (i) can be mapped to the (future) optimal threshold (j), and the histogram (j) can be mapped to the (future) optimal threshold (k).

In some arrangements, the system can create database and labels for training an estimator (e.g., DNN-based FPQT estimator). In some arrangements, a first process for training for generating a training database for FP thresholds estimation begins in step 1-1 by creating a database of voltage thresholds (VT) distribution that contains all stresses that need to be supported by a VT tracking estimator (e.g., FPQT estimator). In some arrangements, the first process begins with creating VT-distributions under all stress conditions that have to be supported, and even beyond, to get a robust estimator. The VT-distributions are also taken from multiple devices and blocks in order to capture the block-to-block and die-to-die variations typical distribution. The VT-distribution is sampled per row according to estimation complexity and characteristics. It may read with a fixed mock thresholds set, where the number of mock thresholds depends on the allowed overhead for QT estimator, and the required accuracy. When using fixed mock thresholds, the thresholds location is optimized so that it captures the typical VT-distribution to enable estimation for all relevant stress conditions.

In step 1-2, a flash memory system (e.g., a controller thereof) can compute optimal thresholds for all rows in database, which serve as labels for training and evaluation. In some arrangements, after reading the VT-distribution with the fixed mock, the controller can compute a histogram for every row in the database. A database row may correspond to a physical NAND die row. In addition, optimal thresholds can be computed from the VT-distribution per row.

In step 1-3, for a given stress that is considered with forward prediction (e.g., data retention (DR)), the controller can evaluate optimal thresholds, and use these thresholds (on corresponding rows in the database) to be evaluated on all lower stress according to their stress strength. For example, for a given DR stress with a data retention time DR1, the controller can use optimal thresholds of DR1 to evaluate fail bit counts (FBC) or bit error rates (BER) with the optimal thresholds of DR1 on cases whose time retention is shorter than DR1.

In some arrangements, the database may contain a table with measured BER values at 1000PPM (=$10^{-3}$). PPM stands for "parts per million" which refers to a probability of $10^{-6}$. A 1000PPM point is a point of probability of $10^{-3}$. The BER of 1000PPM means a BER value at which the probability that errors are above the BER value is $10^{-3}$. In other words, the BER of 1000PPM is a BER value at which complementary cumulative distribution function (CCDF) value is $10^{-3}$. Every row in the table can correspond to an evaluation of a specific data retention (DR) stress condition. For example, a first row denoted by R0 corresponds to a program disturb condition (no retention), a second row denoted by Bake0p5H_55C corresponds to a data retention of 0.5 hours at 55°C, a third row denoted by Bake1H_55C corresponds to a data retention of 1 hour at 55°C, a fourth row denoted by Bake2H_55C corresponds to a data retention of 2 hour at 55°C, and so on. Every column can correspond to a DR case as well. For a given entry (i, j), the i-th DR stress (e.g., i-th row) can be evaluated with the j-th stress optimal thresholds, and the entry can have a value at 1000PPM BER when reading the i-th stress with the j-th stress optimal thresholds. The diagonal values on (i, i) can represent the 1000PPM BER when reading with optimal current thresholds of a target stress. A BER threshold (denoted by BER_TH) can have a value of 1000PPM BER. The BER_TH can be determined according to hard decoding capability, and determined as the highest allowed BER such that performance may not degrade with future stress thresholds. For example, the BER_TH = 0.007 of 1000PPM BER can be used to determine mapping of a future DR stress to a current stress. For Bake0p5H_55C (which indicates 0.5hours at 55°C), the future optimal thresholds of 6Hours at 55°C can provide a value of 1000PPM BER that is less than BER_TH, but any higher DR optimal thresholds exceed the thresholds, and therefore, the system can map the stress condition of Bask0p5H_55C to optimal thresholds of 6Hours at 55°C (corresponding to the condition of Bake6H_55C).

In step 1-4, for all stresses that have optimal thresholds with 1000PPM BER below BER_TH, the controller can select lower stress for mapping as the lowest stress that has 1000 PPM BER below the same BER_TH. In some arrangements, the controller can use read-retry rate (RRR) based FCB_TH (e.g.1000PPM FBC) instead of 1000PPM BER. For example, in the first row denoted by R0, all stresses have optimal thresholds with 1000PPM BER below BER_TH=0.7, and therefore the controller can select thresholds for the lowest stress as the current optimal threshold for R0. On the other hand, in the eleventh row denoted by Bake18H_55C, all the stress conditions with a retention time that is the same as or longer than 18 hours (e.g., Bake18H_55C, Bake24H_55C, Bake30H_55C) are equal to or above BER_TH, and therefore the controller does not select optimal thresholds for Bake18H_55C.

In step 1-5, the controller can define optimal thresholds labels for database rows according to above conditions. For example, the controller can define FP thresholds for the forward predictive stresses (e.g., Bake0p5H_55C, Bake1H_55C, Bake2H_55C, Bake3H_55C, Bake4H_55C). For other stresses for which no forward prediction is applied (e.g., R0, Bake6H_55C, Bake8H_55C, Bake9H_55C, Bake12H_55C), the controller can use current optimal thresholds. In this manner, the first process can enable robust training of FPQT.

In step 1-6, the controller can have the database ready for training. It is noted that the stress condition handled in some arrangements is not limited only to DR (data retention) condition, but also other stress conditions, especially "growing" or "developing" stresses including RD (read disturb) stress. In some arrangements, a DNN estimator can include a function that can classify, categorize, or distinguish major stress conditions, such as "data retention" dominant type, "read disturb" dominant type (as in a read-intensive system), or many kinds of mixed stress type (e.g., RD with DR, cross temperature with DR, etc.).

In some arrangements, the system can perform a second process for training for generating a training database for FP thresholds estimation (FPQT) with an augmented set of VT-distributions. The second process can include steps 2-1, 2-3, 2-4, 2-5, 2-6, 2-7 which are similar to steps 1-1, 1-2, 1-3, 1-4, 1-5, 1-6, respectively. In step 2-2, the system (e.g., controller) can define a stress range for which refined data for future thresholds prediction is required, and perform database augmentation to obtain a fine resolution of stress conditions for forward reference selection on training.

In some arrangements, the controller can optimize the future predictive optimal thresholds with augmented VT-distributions that are generated for providing a training database. In some arrangements, the controller can augment, expand, extend, or enlarge the stresses that are considered for training with future optimal thresholds, in a fine resolution, so that many additional VT-distributions are generated. In this manner, the controller can provide a flexibility in mapping an input mock histogram (or VT-distribution) with a future optimal set of thresholds. In some arrangements, the controller can calculate the range of distributions for augmentation from the BER distribution of target stress conditions. For example, suppose a DR stress is considered for future optimal prediction, and VT-distribution contains a finite set of sample points, e.g., DR of 1 month at 40°C and 1 year at 40°C. Then, the controller can use an augmentation of VT-distributions to generate a typical VT-distribution in a fine grid of 1, 2, 3, ..., 12 months at 40°C. The controller can add all the augmented VT-distributions to the original database, and perform the mapping of optimal thresholds using the combined database. In some arrangements, augmented VT-distributions may include at least one of interpolated distributions and/or extrapolated distributions.

In some arrangements, the system (or controller thereof) can perform a patrol read by executing a third process. In some arrangements, a patrol read for thresholds tracking during idle periods on the storage can be performed periodically. The goal of patrol reads is to maintain fresh up-to-date threshold values for all written blocks, in order to avoid read retries, and thus provide highest achievable performance. During a patrol read, the threshold tracking may also detect blocks that need refresh, and generate a corresponding status (e.g., high BER status or low BER status) for higher level blocks management. The controller can schedule a block-data refresh after patrol is completed, for all blocks with high BER status from patrol. The data refresh can include copying data from a written block that has high BER to a new block (an erased block).

In some arrangements, the third process can begin in step 3-1 by starting a patrol read for every T hours. The third process can keep track of written blocks, and in a periodic manner can issue a patrol read over all dies and written blocks, in order to maintain valid read thresholds. In some arrangements, the patrol command for a die/block can be a threshold tracking command followed by HT update for some predetermined block.

In step 3-2, the controller can hold and maintain a list of written blocks per die that require thresholds refresh. In step 3-3, the controller can examine or check all dies and blocks for patrol read, and for each block, the controller can perform steps 3-4 to 3-9. In step 3-4, for all available dies (assuming there are no other higher priority read/write operations), the controller can determine a next block and send a thresholds-tracking command. In step 3-5, the controller can perform N mock single state reads (e.g., N≥1) with predetermined thresholds (e.g., N predetermined mock thresholds), from a target row. In step 3-6, the controller can compute a histogram H of a VT-distribution from all the single state reads. If the controller preforms N mock single state reads, the histogram H can have N+1 states, where the number of states is N+1 due to having performed N single state reads. In some arrangements, for a QLC device, the controller can perform 4 page reads in predetermined mock thresholds locations, and compute a $2^4=16$ state histogram of the target row. It is noted that read size can be even smaller than a full page for computational complexity limitation on NAND.

In step 3-7, the controller can estimate target row current thresholds (denoted by "Th") from the histogram H using an estimator (e.g., LUT-based, linear, or DNN-based estimator). The controller can estimate or classify a BER status (denoted by "BERStatus") as high BER or low BER. In some arrangements, the computed histogram H can be used by another estimator to estimate the BER level or BER status as a classification estimation for identifying high BER that indicates on data refresh requirements. The estimator can return the BERstatus to the controller, which schedules refresh if needed. The controller can perform a thresholds tracking and/or a HT update on a mock histogram to estimate current optimal thresholds.

In step 3-8, the controller can receive Th and/or BERStatus as input to an HT-Set operation for a target block, and perform the HT-Set operation. In step 3-9, the controller can determine whether the threshold-tracking is completed for scheduled dies and/or blocks. In step 3-10, in response to determining that the threshold-tracking is not completed, the controller can continue to the next block (proceed to step 3-4) with the BERStatus. In step 3-11, in response to determining that the threshold-tracking is completed, the controller can complete the patrol read.

In some arrangements, the system can perform a forth process for performing a patrol read with future predictive (FP) thresholds. The forth process can include steps 4-2, 4-3, 4-4, 4-5, 4-6, 4-8, 4-9, 4-10, 4-11 which are similar to steps 3-2, 3-3, 3-4, 3-5, 3-6, 3-8, 3-9, 3-10, 3-11, respectively. In step 4-1, the system (e.g., controller) can start patrol read for every U (>T) hours (e.g., 2T hours which is twice longer than T hours in the third process). In step 4-7, the controller can estimate target row future thresholds (e.g., FP thresholds denoted by "Th") from histogram H using at least one of a LUT-based estimator, a linear estimator or a DNN-based estimator. The controller can estimate or classify a BER status (denoted by "BERStatus") as high BER or low BER. The results of the FP threshold estimation can be used for HT update (e.g., step 4-8) and further reads from each block (e.g., step 4-9) that undergoes patrol read.

In some arrangements, the system (e.g., controller) can perform a fifth process that executes a generic estimator of FP thresholds. The fifth process can begin in step 5-1 by starting threshold tracking with a current read. In step 5-2, the controller can keep or hold an existing current read result (e.g., a read result obtained during a previous retry state), and determine additional page types to read. Here, the read result may not be a read result with fixed mock thresholds, but an existing read result, with arbitrary read thresholds, which can be the read thresholds used for last read from NAND which might have failed on HB decoding.

In step 5-3, the controller can perform additional page reads for a target row based on additional page types, in predetermined mock locations. For example, suppose that the controller issues a lower-page read and decoding fails. In QLC (which has 4 page types per row), the system can perform additional reads of a middle-page, a upper-page, and a top-page, with designated mock thresholds locations (e.g., mock thresholds) for these supplemental reads. In this manner, the system can obtain a high resolution histogram (with up to 16 bins), from which an accurate thresholds estimation can be performed. In step 5-4, the controller can compute a histogram H of VT distributions from all single state reads. In step 5-5, the controller can execute a DNN-based estimator of future (FP) thresholds using all features input (e.g., threshold shift values, row index, read temperature, program temperature, etc.). In some arrangements, the read result in step 5-2, optionally additional page reads maybe from other page types in step 5-3, or single state reads to obtain separated per threshold histogram, can be combined as combined reads. In some arrangements, controller can use the combined reads to compute a histogram, and provide all read shift thresholds used for histogram computation to the DNN-based estimator. The DNN-based estimator can receive additional features if available, such as cycle count, row index, read temperature, program temperature, etc.

In some arrangements, the estimator can output FP thresholds (FPThresholds) and/or current thresholds (currThresholds). In step 5-6, the controller can receive the FP thresholds and perform HT-Set operation for the target block using the FP thresholds. The FPThresholds can be used for updating the HT index for the block. In some arrangements, the FPThresholds can be used for all purposes, including current read, as the training takes into account a limited effect on BER. In step 5-7, the controller can receive the current thresholds and perform a current read using the current thresholds. The training process for this generic FP estimator can be similar in its design to the QT with fixed mock thresholds. The main difference may be how the database is generated. In training the generic FP estimator, the database can include results (e.g., VT distributions) of reads with different possible thresholds, which can induce different histograms for an identical row, thereby building a much larger database to cover all stress cases.

In some arrangements, the system (e.g., controller) can perform a sixth process that perform dynamic inter-cell-interference (ICI) FP thresholds estimation. The sixth process can begin in step 6-1 by performing dynamic ICI page read from NAND without decoding. In step 6-2, the controller can read a neighbor row in a predetermined fixed threshold into an internal buffer. The neighbor row may be an interference source, e.g., WL(n+1). In NAND devices, there is usually interference from neighboring cells such as next WL or previous WL. This interference may vary due to stress conditions. For example, under a high retention stress or a high read disturb stress, the ICI effect may be more severe. Therefore, the controller may need to estimate the interference compensation parameters, which means estimating the optimal thresholds per ICI state. The characterization of the ICI effect as function of the stress conditions can be done offline, and be used for training the estimator. In some arrangements, the optimal thresholds for dynamic ICI compensation can be estimated to a future state (e.g., higher retention, or higher read disturb) using FPQT methods based on histograms that are computed jointly from mock read thresholds and neighbor row interference reads.

In step 6-3, the controller may perform N mock single state reads (N≥1) with predetermined thresholds, from a target row. In step 6-4, the controller may compute a joint histogram H of VT distributions of ICI reads and single state reads. In step 6-5, the controller may estimate future target page read thresholds (e.g., FP thresholds for a target page read) from the histogram H using at least one of a LUT-based estimator, a linear estimator, or a DNN-based estimator. In step 6-6, the controller may read a target page using the estimated FP thresholds according to the number of ICI states. In step 6-7, the controller may select a per-ICI state of page data according to the read results using thresholds corresponding to the per-ICI state. The selected per-ICI state of page data may be the ICI compensation. An ICI state refers to a VT level or range of levels of an interference source. In some arrangements, the system can read all the target page cells that have interference of this ICI state, with the estimated thresholds of this ICI state. After performing the reading for all states, the system can combine the page information into a single page result which includes read results from all ICI states.

According to certain aspects, arrangements in the present disclosure relate to a method for performing operations on a non-volatile memory. The method may include determining, by a machine learning model at a first time point, a plurality of voltage thresholds for read operations on the non-volatile memory, based on one or more stress conditions at the first time point, wherein the plurality of voltage thresholds correspond to respective time durations since the first time point. The method may include obtaining, from the plurality of voltage thresholds, one or more voltage thresholds associated with a particular time duration of the respective time durations. The method may include performing, at a second time point that is later than the first time point by the particular time duration, a read operation on the non-volatile memory with the one or more voltage thresholds associated with the particular time duration.

According to certain aspects, arrangements in the present disclosure relate to a flash memory system including a non-volatile memory and a circuit for performing operations on the non-volatile memory. The circuit may be configured to determine, by a machine learning model at a first time point, a plurality of voltage thresholds for read operations on the non-volatile memory, based on one or more stress conditions at the first time point. The plurality of voltage thresholds may correspond to respective time durations since the first time point. The circuit may be configured to obtain, from the plurality of voltage thresholds, one or more voltage thresholds associated with a particular time duration of the respective time durations. The circuit may be configured to perform, at a second time point that is later than the first time point by the particular time duration, a read operation on the non-volatile memory with the one or more voltage thresholds associated with the particular time duration. In some arrangements, the one or more stress conditions may include at least one of read disturb, data retention loss, temperature variations, mechanical stress, or error rate stress. In some arrangements, the plurality of voltage thresholds may include at least one of voltage thresholds used for mock reads, voltage thresholds as a result of mock reads, or voltage thresholds used for reads of a particular page.

In some arrangements, in determining the plurality of voltage thresholds, the circuit may be configured to obtain a first set of voltage thresholds for respective stress conditions associated with different time durations. The circuit may be configured to select, as a voltage threshold for a stress condition associated with the particular time duration, one voltage threshold from the first set of voltage thresholds.

In some arrangements, in selecting the one voltage threshold, the circuit may be configured to determine, among the first set of voltage thresholds, a second set of voltage thresholds associated with a plurality of bit error rates (BERs) that are less than a threshold BER, each of the plurality of BERs being measured when performing a read operation with a corresponding voltage threshold of the second set of voltage thresholds under the stress condition associated with the particular time duration. The circuit may be configured to determine, as the voltage threshold for the stress condition associated with the particular time duration, a voltage threshold associated with a largest BER among the second set of voltage thresholds.

In some arrangements, in determining the plurality of voltage thresholds, the circuit may be configured to obtain one or more voltage thresholds for a first stress condition associated with a first time duration. The circuit may be configured to obtain one or more voltage thresholds for a second stress condition associated with a second time duration that is larger than the first time duration. The circuit may be configured to determine one or more voltage thresholds for one or more stress conditions associated with one or more time durations that are larger than the first time duration and smaller than the second time duration.

In some arrangements, in determining the plurality of voltage thresholds, the circuit may be configured to periodically perform a periodic read operation during an idle period on the non-volatile memory. In response to performing the periodic read operation, the circuit may be configured to determine, by the machine learning model, the plurality of voltage thresholds for read operations, based on a result of the periodic read operation.

In some arrangements, the circuit may configured to store a plurality of voltage thresholds for each of a plurality of rows of cells. The non-volatile memory may include one or more blocks, each block including the plurality of rows of cells. The circuit may configured to update, at the second time point, the plurality of voltage thresholds for each row with the one or more voltage thresholds associated with the particular time duration.

In some arrangements, the circuit may be configured to store, in a look-up table, the plurality of voltage thresholds for each row. The circuit may be configured to update, at the second time point, the look-up table with the one or more voltage thresholds associated with the particular time duration. In performing the read operation on the non-volatile memory, the circuit may be configured to obtain a row identifier identifying a row of a target page, among the plurality of rows. The circuit may be configured to identify, using the updated look-up table, a third set of voltage thresholds for the read operation, based on the row identifier. The circuit may be configured to perform the read operation on the target page of the non-volatile memory with the third set of voltage thresholds.

In some arrangements, in determining the plurality of voltage thresholds, the circuit may be configured to perform one or more read operations on a target row of the plurality of rows of cells. The circuit may be configured to receive as input to the machine learning model, one or more features and a result of the one or more read operations. The circuit may be configured to determine as output of the machine learning model, the plurality of voltage thresholds. The one or more features may include an index corresponding to a subset of the one or more stress conditions, a row index identifying a row, a read temperature, or a program temperature. The result of the further read operation may include a histogram calculated based on states of the one or more read operations.

In some arrangements, in determining the plurality of voltage thresholds, the circuit may be configured to perform inter-cell-interference (ICI) read operations on one or more rows of neighboring cells. The circuit may be configured to perform single state read operations on a target row of the plurality of rows of cells. The circuit may be configured to receive as input to the machine learning model, results of the ICI read operations and the single state read operations. The circuit may be configured to determine as output of the machine learning model, the plurality of voltage thresholds. The results of the ICI read operations and the single state read operations may include a joint histogram of states of the ICI read operations and the single state read operations.

Arrangements in the present disclosure have at least the following advantages and benefits. First, arrangements in the present disclosure can achieve high read performance from NAND flash devices following VT estimation. The VT estimation can be targeted future compatible read thresholds, which can be optimal for later in time for a developing stress (e.g., read disturb, data retention loss, temperature variations, mechanical stress, or error rate stress, etc.). The estimated thresholds can be used for longest duration under typical stress conditions thereby maximizing the duration between failures and significantly reducing the frequency of patrol reads. As a result, the probability of retry can be reduced and the available read bandwidth can be increased.

Second, arrangements in the present disclosure can perform a dynamic inter-cell-interference (ICI) compensation estimation with future VT estimation. For example, a flash memory system can estimate thresholds that support, consider or take into account a future data retention (DR) ICI effect (e.g., stronger interference), and enable a longer duration of ICI compensation without retries.

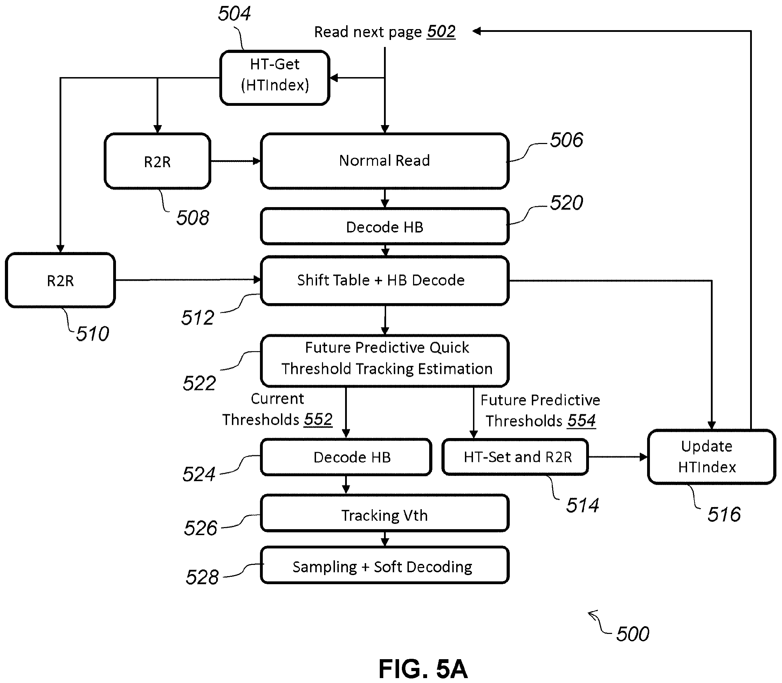

Referring to FIGS. 5A-15, arrangements of systems and methods for the present solution to estimate voltage thresholds for use at a later time based on current voltage threshold distributions and/or current stress conditions are described and illustrated.

FIG. 5A illustrates an example of read flow 500 including future predictive (FP) thresholds estimation, according to some arrangements. Steps 504, 506, 508, 510, 512, 520, 524, 526, 528 can be similar to steps 404, 406, 408, 410, 412, 420, 424, 426, 428 as shown in FIG. 4A, respectively. In some arrangements, the read flow shown in FIG. 5A includes receiving and/or executing a read command to a target page (step S502). A flash memory system (e.g., a controller of a flash memory system) can perform a HT-Get operation to extract a HTIndex that keeps the state of the block and points to the type of read on a first stage (e.g., first phase read) (step S504). For example, if HTIndex is equal to 0, then first-phase reads can be performed with read thresholds according to a row of a target page (step S506). For example, when using a DNN-based R2R estimator (step S508), for HTIndex=0, the read thresholds can be $DNN(0,row)$ (see Equation 3) which corresponds to a DNN output. If HTIndex has another value that is up to (or less than or equal to) the number of entries in retry-fixed thresholds table (step S510), then $DNN(HTIndex,row)$ (see Equation 3) can be used to provide the read thresholds (step S512). If (or only if) HTIndex is higher than the number of retry-fixed thresholds-table entries, then HTIndex can refer to a codebook that provides the corresponding thresholds, which are extracted from a LUT. The LUT is a codebook such that the input of the LUT is the HTindex (same as shiftIdx), and the output of the LUT are thresholds for reference row ($TH_{HT-ref}$). An R2R estimator can provide the target row thresholds using $DNN(ShiftIdx,row,TH_{HT-ref})$ (see Equation 4).

The system can perform a future predictive quick threshold tracking (FPQT) (step S522) to estimate current thresholds 552 and future predictive (FP) In case of HB decoding failure (e.g., step S520) on normal read (e.g., step S506) and all shift-table read retries (e.g., step S512), the system can perform a FP threshold estimation (also referred to as "FPQT") which can estimate FP thresholds 554, as well as current optimal thresholds 552. The system (e.g., controllers of a flash memory system) can perform FPQT as typical stages for read-retry in case of failures. In response to determining decoding fails with all shift-table candidates (e.g., step S512), the system can perform FPQT (step S522) to estimate optimal thresholds of the current row. The system can perform FPQT by performing a few mock reads with fixed thresholds, from which a histogram is computed. The system can use one or more estimators with the histogram for estimating both current thresholds 552 and FP thresholds 554. The one or more estimators can include a linear estimator and/or a machine learning-based (e.g., DNN-based) estimator. The system can configure NAND with the current estimated thresholds 552 for a retry read and HB decode (step S524). The system can use an R2R operation (LUT-based R2R or DNN-based R2R) to transfer or convert the FP thresholds 554 to reference row FP thresholds, and use these reference row FP thresholds for updating the HT table (HT-Set operation in step S514). The system can perform HT-Set by compressing the estimated FP thresholds (e.g., reference row FP thresholds) into an index pointer HTindex for the HT table (step S516). The HTindex can point to HT thresholds that are closest to the estimated FP thresholds, and can be used for subsequent reads from the same block. In some arrangements, the system can estimate only FP thresholds that are to be used after FPQT for HB decode and for HT-Set. This can save an estimation process, and provide sufficient reliability, which is guaranteed during the training of the estimator.

After performing FPQT in step S522, an HTIndex to FP thresholds 554 can be computed using the HT-Set operation (step S514), which can be implemented by a K-means search algorithm, and the HTIndex can be updated (step S516). In some arrangements, the FP thresholds 554 can be associated with a particular duration since a particular time point (e.g., a first time point). When reading a next page in step S502 at a second time point which is later than the first time point by the particular duration associated with the FP thresholds 554, the system can perform a read using the FP thresholds 554 (e.g., by searching the history table for the FP thresholds 554).

After performing FPQT in step S522, the system can configure estimated current thresholds 552 to NAND, and perform a read-retry, followed by HB decoding (step S524). If HB decoding fails, then the controller may perform a higher complexity threshold tracking (step S526), e.g., pre-soft tracking (PST), followed by sampling and/or soft decoding (step S528).

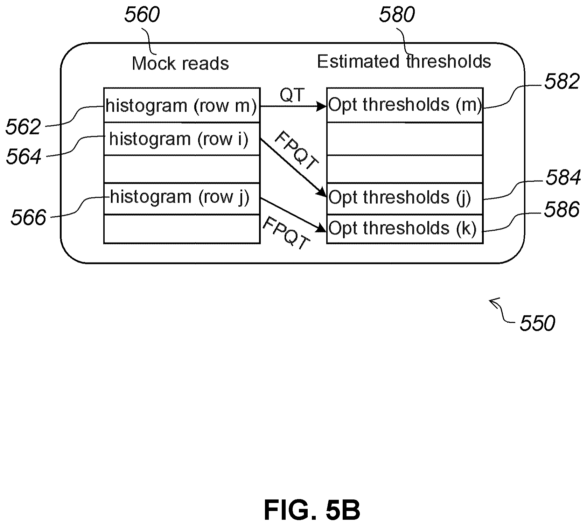

FIG. 5B illustrates an example of a database 550 or database mapping for training FP thresholds estimation/-tracking, according to some arrangements. In some arrangements, the system can train FP thresholds estimators (also referred to as "FPQT estimators"; e.g., DNN-based FPQT estimators) using a database 550 (as training data) storing histograms 560 based on mock reads and optimal thresholds 580 at respective rows (e.g., rows m, i, j, k). For example, the database 550 can store histogram (m) 562, histogram (i) 564, histogram (j) 566 at rows m, i, and j, respectively, and store optimal thresholds (m) 582, optimal thresholds (j) 584, optimal thresholds (k) 586 at rows m, j, and k, respectively. The histograms can be taken from mock-thresholds reads (e.g., during FPQT in step S522) of VT-distributions of many stress conditions. The optimal thresholds can serve as labels in training.

Referring to FIG. 5B, some rows (e.g., row i, row j) which correspond to stresses with future relevant thresholds can be mapped to labels that provide a good prediction of optimal thresholds as the stress evolves. Horizontal connections (between the same stress condition) can connect current optimal thresholds mapping, and diagonal connections (between different stress conditions) can connect rows that are mapped to future optimal thresholds. For example, a histogram in a particular row (e.g., histogram (m) 562) can be mapped to the current optimal thresholds (e.g., optimal threshold (m) 582). A histogram in a particular row can be mapped to future optimal thresholds in a different row. For example, the histogram (i) 564 can be mapped to the (future) optimal threshold (j) 584, and the histogram (j) 566 can be mapped to the (future) optimal threshold (k) 586.

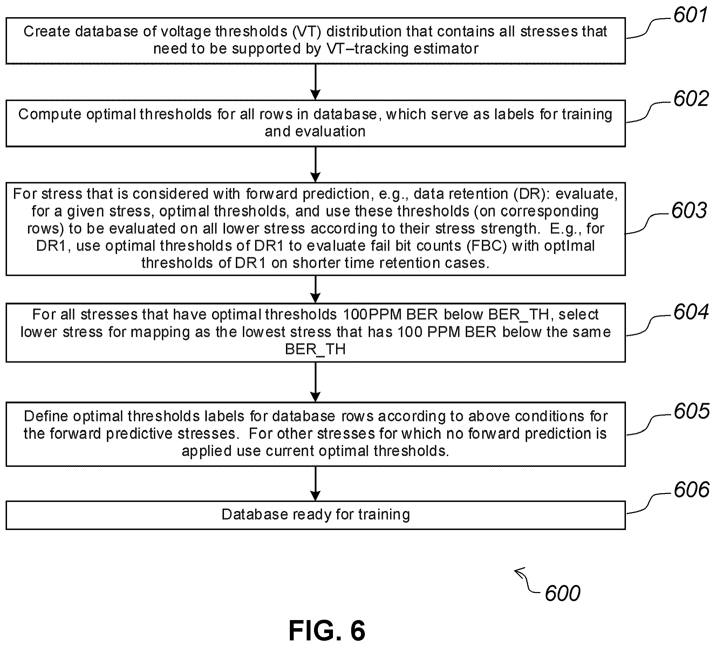

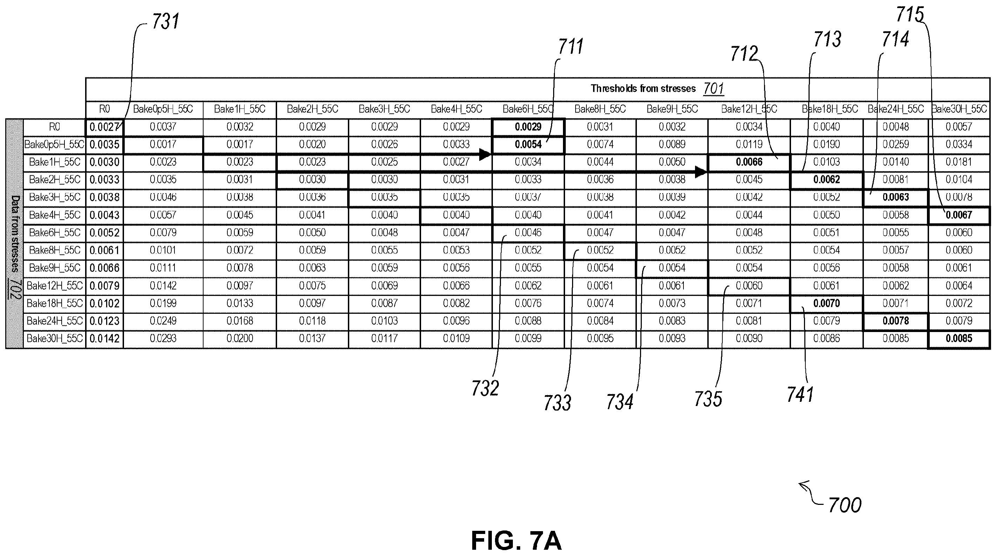

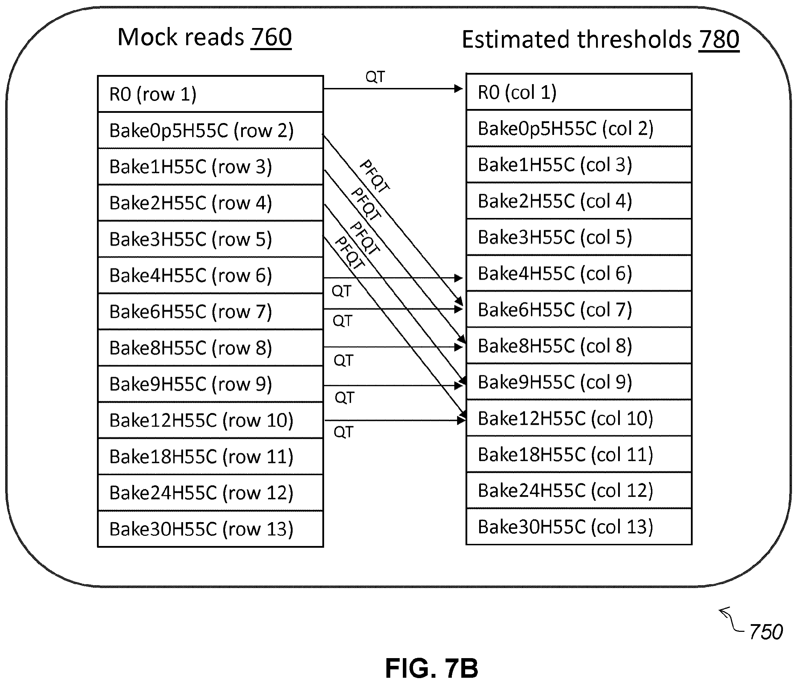

FIG. 6 is a flowchart illustrating an example methodology for generating a training database for FP thresholds estimation, according to some arrangements. FIG. 7A and FIG. 7B illustrate an example of selecting future optimal thresholds mapping to future stress cases, according to some arrangements.

Referring to FIG. 6, a flash memory system (e.g., a controller thereof) can create database and labels for training an estimator (e.g., DNN-based FPQT estimator) by executing a process 600 for training for generating a training database for FP thresholds estimation. The process 600 can begin in step S601 by creating a database of voltage thresholds (VT) distribution that contains all stresses that need to be supported by a VT tracking estimator (e.g., FPQT estimator). The process 600 can begin with creating VT-distributions under all stress conditions that have to be supported, and even beyond, to get a robust estimator.

In step S602, the controller can compute optimal thresholds for all rows in database, which serve as labels for training and evaluation. In some arrangements, after reading the VT-distribution with the fixed mock (e.g., FPQT in step S522), the controller can compute a histogram for every row in the database. A database row may correspond to a physical NAND die row. In addition, the controller can compute optimal thresholds from the VT-distribution per row.

In step S603, for a given stress that is considered with forward prediction (e.g., data retention (DR)), the controller can evaluate optimal thresholds, and use these thresholds (on corresponding rows in the database) to be evaluated on all lower stress according to their stress strength. For example, for a given DR stress with a data retention time DR1, the controller can use optimal thresholds of DR1 to evaluate fail bit counts (FBC) or bit error rates (BER) with the optimal thresholds of DR1 on cases whose time retention is shorter than DR.

Referring to FIG. 7A, the database may contain a table 700 with measured BER values at 1000PPM. Every row (e.g., 13 rows 702) in the table 700 can correspond to an evaluation of a specific data retention (DR) stress condition. For example, a first row denoted by R0 corresponds to a program disturb condition (no retention), a second row denoted by Bake0p5H_55C corresponds to a data retention of 0.5 hours at 55°C, a third row denoted by Bake1H_55C corresponds to a data retention of 1 hour at 55°C, a fourth row denoted by Bake2H_55C corresponds to a data retention of 2 hour at 55°C, and so on. Every column (e.g., 13 columns 701) in the table 700 can correspond to a DR case as well. For a given entry (i, j), the i-th DR stress (e.g., i-th row) can be evaluated with the j-th stress optimal thresholds, and the entry can have a value at 1000PPM BER when reading the i-th stress with the j-th stress optimal thresholds. The diagonal values on (i, i) can represent the 1000PPM BER when reading with optimal current thresholds of a target stress. A BER threshold (denoted by BER_TH) can have a value of 1000PPM BER. The BER_TH can be determined according to hard decoding capability, and determined as the highest allowed BER such that performance may not degrade with future stress thresholds. For example, the BER_TH = 0.007 of 1000PPM BER can be used to determine mapping of a future DR stress to a current stress. For Bake0p5H_55C (which indicates 0.5hours at 55°C), the future optimal thresholds of 6Hours at 55°C can provide a value 711 of 1000PPM BER (0.0054) that is less than BER_TH=0.07, but any higher DR optimal thresholds exceed the thresholds, and therefore, the system or controller can map the stress condition of Bask0p5H_55C to optimal thresholds of 6Hours at 55°C (corresponding to the condition of Bake6H_55C). In a similar manner, the controller can map the stress condition of Bask1H_55C to optimal thresholds of 12Hours at 55°C with BER 712, map the stress condition of Bask2H_55C to optimal thresholds of 18Hours at 55°C with BER 713, map the stress condition of Bask3H_55C to optimal thresholds of 24Hours at 55°C with BER 714, and map the stress condition of Bask4H _55C to optimal thresholds of 30Hours at 55°C with BER 715.

In step S604, for all stresses that have optimal thresholds with 1000PPM BER below BER_TH, the controller can select lower stress for mapping as the lowest stress that has 1000 PPM BER below the same BER_TH. In some arrangements, the controller can use read-retry rate (RRR) based FCB_TH (e.g.1000PPM FBC) instead of 1000PPM BER. For example, in the first row denoted by R0, all stresses have optimal thresholds with 1000PPM BER below BER_TH=0.7, and therefore the controller can select thresholds for the lowest stress with BER 731 as the current optimal threshold for R0. On the other hand, in the eleventh row denoted by Bake18H_55C, all the stress conditions with a retention time that is the same as or longer than 18 hours (e.g., Bake18H_55C, Bake24H_55C, Bake30H_55C) are equal to or above BER_TH=0.007 (e.g., BER 741 has a value of 0.007 which is equal to BER_TH), and therefore the controller does not select or determine optimal thresholds for Bake18H_55C. For similar reasons, the controller does not select or determine optimal thresholds for Bake24H_55C and Bake30H_55C.

In step S605, the controller can define optimal thresholds labels for database rows according to above conditions. For example, the controller can define FP thresholds for the forward predictive stresses (e.g., Bake0p5H_55C, Bake1H_55C, Bake2H_55C, Bake3H_55C, Bake4H_55C). For other stresses for which no forward prediction is applied (e.g., R0, Bake6H_55C, Bake8H_55C, Bake9H_55C, Bake12H_55C), the controller can use current optimal thresholds corresponding to BER values 731, 732, 733, 734, 735. In this manner, the process 600 can enable robust training of FPQT. In step S606, the controller can have the database ready for training.

FIG. 7B illustrates an example of a database 750 or database mapping for training FP thresholds estimation/-tracking, as a result of executing the process 600. In some arrangements, the system can train FPQT estimators using the database 750 (as training data) storing histograms 760 based on mock reads and optimal thresholds 780 at respective rows (e.g., rows 1 to 13). For example, the database 750 can store histograms corresponding to the 13 rows 702, and store optimal thresholds corresponding to the 13 columns 701. The histograms can be taken from mock-thresholds reads (e.g., during FPQT in step S522) of VT-distributions of many stress conditions. The optimal thresholds can serve as labels in training. Some rows (e.g., rows 2 to 5) which correspond to stresses with future relevant thresholds can be mapped (e.g., PFQT mapping) to labels that provide a good prediction of optimal thresholds as the stress evolves. Horizontal connections (between the same stress condition; e.g., row 1 and rows 6-10) can connect current optimal thresholds mapping (e.g., QT mapping), and diagonal connections (between different stress conditions; e.g., rows 2 to 5) can connect rows that are mapped to future optimal thresholds (e.g., PFQT mapping).

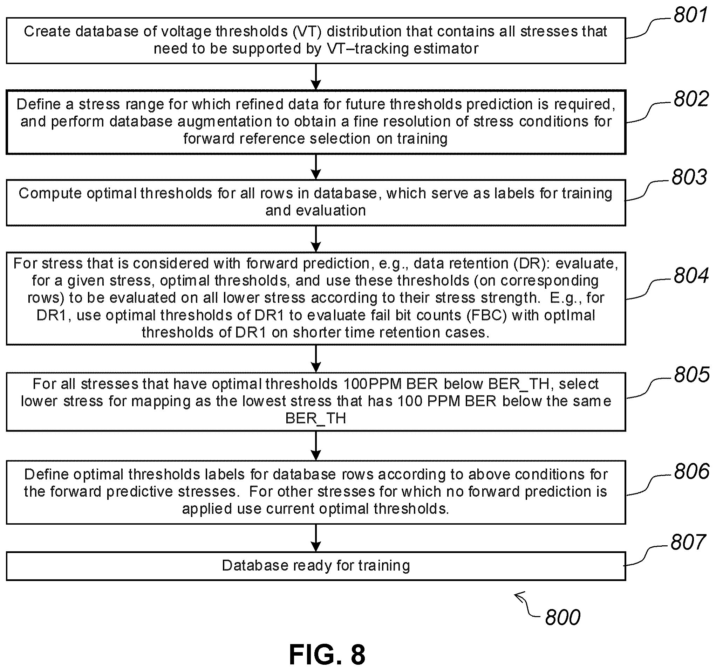

FIG. 8 is a flowchart illustrating another example methodology for generating a training database for training for FP thresholds estimation, according to some arrangements. A flash memory system (e.g., a controller thereof) can perform a process 800 for training for generating a training database for FP thresholds estimation (FPQT) with an augmented set of VT-distributions. The process 800 can include steps S801, S803, S804, S805, S806, S807 which are similar to steps S701, S702, S703, S704, S705, S706, respectively. In step S802, the system (e.g., controller) can define a stress range for which refined data for future thresholds prediction is required, and perform database augmentation to obtain a fine resolution of stress conditions for forward reference selection on training. For example, suppose a DR stress is considered for future optimal prediction, and VT-distribution contains a finite set of sample points, e.g., DR of 1 month at 40°C and 1 year at 40°C. Then, the controller can use an augmentation of VT-distributions to generate a typical VT-distribution in a fine grid of 1, 2, 3, ..., 12 months at 40°C. The controller can add all the augmented VT-distributions to the original database, and perform the mapping of optimal thresholds using the combined database. In some arrangements, augmented VT-distributions may include at least one of interpolated distributions and/or extrapolated distributions.

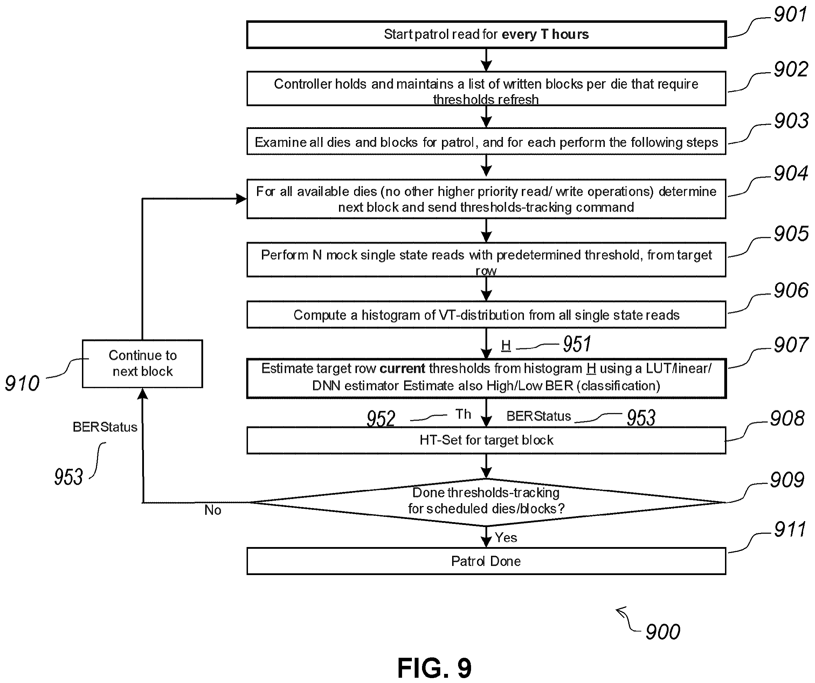

FIG. 9 is a flowchart illustrating an example methodology for performing a patrol read, according to some arrangements. A flash memory system (e.g., a controller thereof) can perform a patrol read by executing a process 900. The process 900 can begin in step S901 by starting a patrol read for every T hours. The process 900 can keep track of written blocks, and in a periodic manner can issue a patrol read over all dies and written blocks, in order to maintain valid read thresholds. In step S902, the controller can hold and maintain a list of written blocks per die that require thresholds refresh. In step S903, the controller can examine or check all dies and blocks for patrol read, and for each block, the controller can perform steps S904 to S909. In step S904, for all available dies (assuming there are no other higher priority read/write operations), the controller can determine a next block and send a thresholds-tracking command. In step S905, the controller can perform N mock single state reads (e.g., N≥1) with predetermined thresholds (e.g., N predetermined mock thresholds), from a target row. In step S906, the controller can compute a histogram H (951) of a VT-distribution from all the single state reads. If the controller preforms N mock single state reads, the histogram H 951 can have N+1 states, where the number of states is N+1 due to having performed N single state reads. In some arrangements, for a QLC device, the controller can perform 4 page reads in predetermined mock thresholds locations, and compute a $2^4=16$ state histogram of the target row. It is noted that read size can be even smaller than a full page for computational complexity limitation on NAND.

In step S907, the controller can estimate target row current thresholds Th (952) from the histogram H 951 using an estimator (e.g., LUT-based, linear, or DNN-based estimator). The controller can estimate or classify a BER status (BERStatus 953) as high BER or low BER. In some arrangements, the computed histogram H can be used by another estimator to estimate the BER level or BER status as a classification estimation for identifying high BER that indicates on data refresh requirements. The estimator can return the BERstatus 953 to the controller, which schedules refresh if needed. The controller can perform a thresholds tracking and/or a HT update on a mock histogram to estimate current optimal thresholds.

In step S908, the controller can receive Th 952 and/or BERStatus 953 as input to an HT-Set operation for a target block, and perform the HT-Set operation. In step S909, the controller can determine whether the threshold-tracking is completed for scheduled dies and/or blocks. In step S910, in response to determining that the threshold-tracking is not completed, the controller can continue to the next block (proceed to step S904) with the BERStatus 953. In step S911, in response to determining that the threshold-tracking is completed, the controller can complete the patrol read.

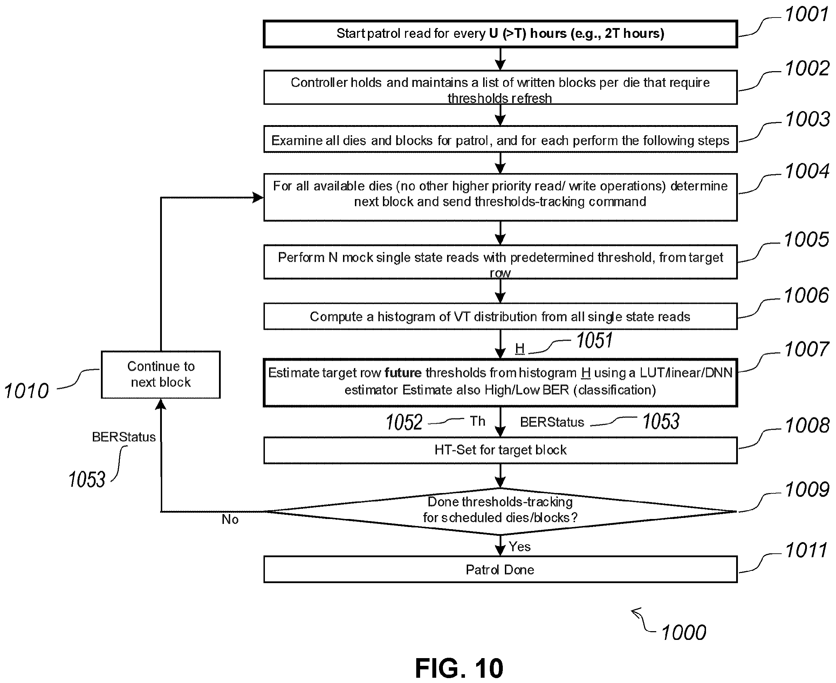

FIG. 10 is a flowchart illustrating another example methodology for performing a patrol read, according to some arrangements, according to some arrangements. In some arrangements, the system can perform a forth process for performing a patrol read with future predictive (FP) thresholds. The forth process can include steps S1002, S1003, S1004, S1005, S1006, S1008, S1009, S1010, S1011 which are similar to steps S902, S903, S904, S905, S906, S908, S909, S9010, S9011, respectively. In step S1001, the system (e.g., controller) can start patrol read for every U (>T) hours (e.g., 2T hours which is twice longer than T hours in the third process). In step S1007, the controller can estimate target row future thresholds (e.g., FP thresholds denoted by "Th") from histogram H using at least one of a LUT-based estimator, a linear estimator or a DNN-based estimator. The controller can estimate or classify a BER status (denoted by "BERStatus") as high BER or low BER. The results of the FP threshold estimation can be used for HT update (e.g., step S1008) and further reads from each block (e.g., step S1009) that undergoes patrol read.

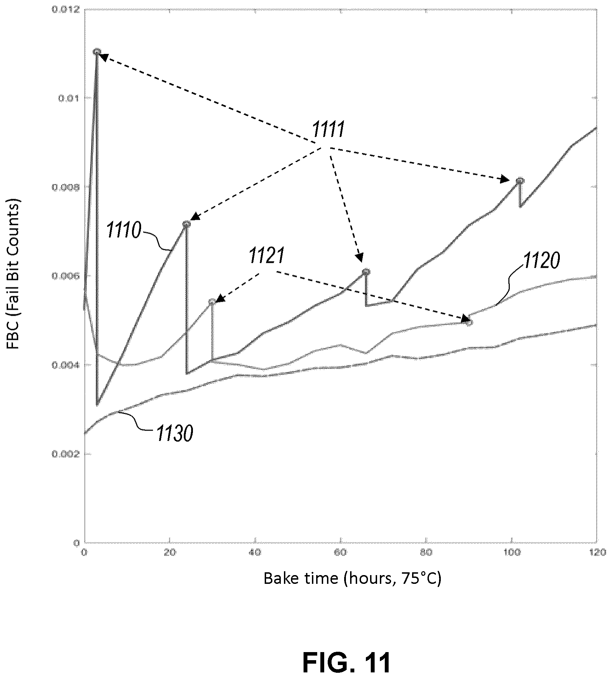

FIG. 11 illustrates a diagram illustrating example results of fail bit counts (FBC) for evaluating patrol reads using future predictive quick training (FPQT), according to some arrangements. The curve 1110 indicates an empirical BER evaluated using a conventional patrol read that occurs every time BER>$6e^{-3}$, and estimates current optimal thresholds, and also does not use R2R. The curve 1120 indicates a maximal empirical BER evaluated over time under 75°C when using FPQT with R2R. The curve 1130 indicates an optimal BER. FIG. 11 shows that the convention patrol read has 4 patrol updates while the FPQT-based patrol read has only 2 patrol updates. It clearly indicates that patrol frequency with FPQT can be reduced by more than two times compared to the conventional patrol read. This can improve read performance, and save power.

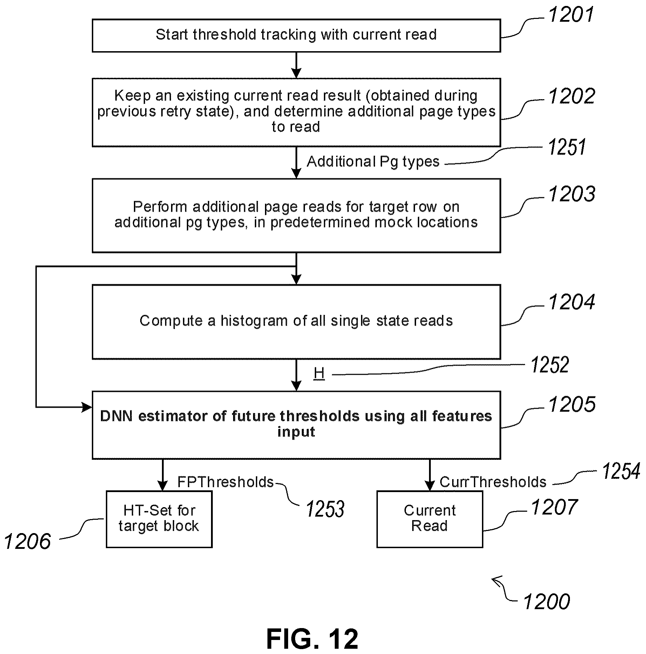

FIG. 12 is a flowchart illustrating an example methodology for a generic estimator of FP thresholds, according to some arrangements. A flash memory system (e.g., a controller thereof) can perform a process 1200 that executes a generic estimator of FP thresholds. The process 1200 can begin in step S1201 by starting threshold tracking with a current read. In step S1202, the controller can keep or hold an existing current read result (e.g., a read result obtained during a previous retry state), and determine additional page types 1251 to read. Here, the read result may not be a read result with fixed mock thresholds, but an existing read result, with arbitrary read thresholds, which can be the read thresholds used for last read from NAND which might have failed on HB decoding.

In step S1203, the controller can perform additional page reads for a target row based on additional page types, in predetermined mock locations. In step S1204, the controller can compute a histogram H 1252 of VT distributions from all single state reads. In step S1205, the controller can execute a DNN-based estimator of future (FP) thresholds using all features input (e.g., threshold shift values, row index, read temperature, program temperature, etc.). In some arrangements, the read result in step S1202, optionally additional page reads maybe from other page types in step S1203, or single state reads to obtain separated per threshold histogram, can be combined as combined reads. In some arrangements, controller can use the combined reads to compute a histogram, and provide all read shift thresholds used for histogram computation to the DNN-based estimator. The DNN-based estimator can receive additional features if available, such as cycle count, row index, read temperature, program temperature, etc.

In some arrangements, the estimator can output FP thresholds (FPThresholds 1253) and/or current thresholds (currThresholds 1254). In step S1206, the controller can receive the FP thresholds and perform HT-Set operation for the target block using the FP thresholds 1253. The FPThresholds can be used for updating the HT index for the block. In some arrangements, the FPThresholds can be used for all purposes, including current read, as the training takes into account a limited effect on BER. In step S1207, the controller can receive the current thresholds 1254 and perform a current read using the current thresholds 1254. The training process for this generic FP estimator can be similar in its design to the QT with fixed mock thresholds. The main difference may be how the database is generated. In training the generic FP estimator, the database can include results (e.g., VT distributions) of reads with different possible thresholds, which can induce different histograms for an identical row, thereby building a much larger database to cover all stress cases.

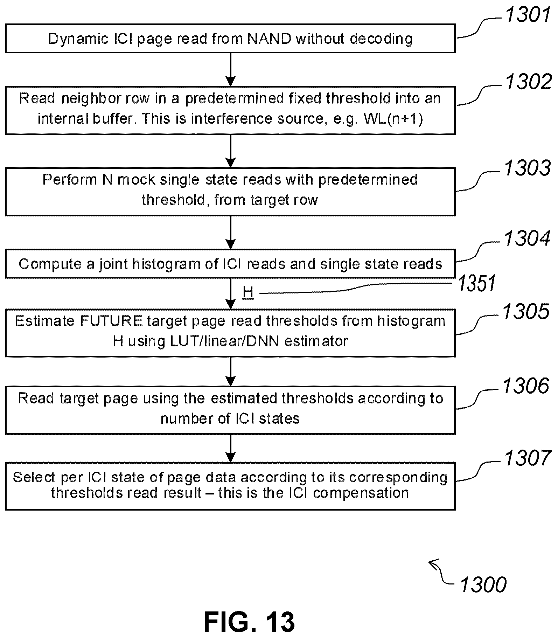

FIG. 13 is a flowchart illustrating another example methodology for dynamic inter-cell-interference (ICI) FP thresholds estimation, according to some arrangements. A flash memory system (e.g., a controller thereof) can perform a process 1300 that perform ICI FP thresholds estimation. The process 1300 can begin in step S1301 by performing dynamic ICI page read from NAND without decoding. In step S1302, the controller can read a neighbor row in a predetermined fixed threshold into an internal buffer. The neighbor row may be an interference source, e.g., word line WL(n+1). In NAND devices, there is usually interference from neighboring cells such as next WL or previous WL. This interference may vary due to stress conditions. For example, under a high retention stress or a high read disturb stress, the ICI effect may be more severe. Therefore, the controller may need to estimate the interference compensation parameters, and it would not be accurate to characterize it once offline. In some arrangements, the optimal thresholds for dynamic ICI compensation can be estimated to a future state (e.g., higher retention, or higher read disturb) using FPQT methods based on histograms that are computed jointly from mock read thresholds and neighbor row interference reads.

In step S1303, the controller may perform N mock single state reads (N≥1) with predetermined thresholds, from a target row. In step S1304, the controller may compute a joint histogram H (1351) of VT distributions of ICI reads and single state reads. In step S1305, the controller may estimate future target page read thresholds (e.g., FP thresholds for a target page read) from the histogram H using at least one of a LUT-based estimator, a linear estimator, or a DNN-based estimator. In step S1306, the controller may read a target page using the estimated FP thresholds according to the number of ICI states. In step S1307, the controller may select a per-ICI state of page data according to the read results using thresholds corresponding to the per-ICI state. The selected per-ICI state of page data may be the ICI compensation.

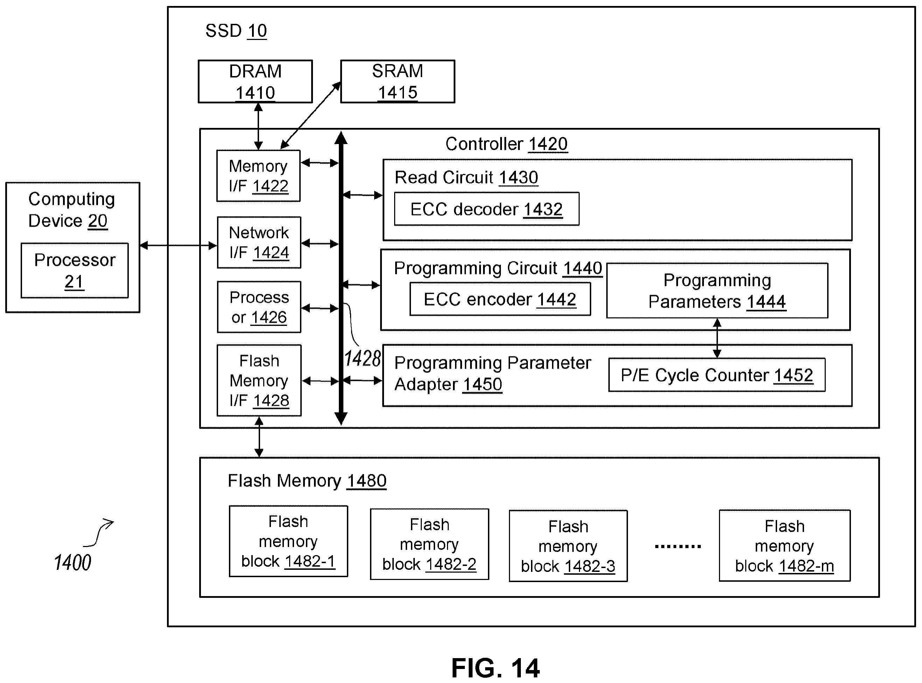

FIG. 14 is a block diagram illustrating an example flash memory system according to some arrangements. Referring to FIG. 14, a flash memory system 1400 may include a computing device 20 and a solid-state drive (SSD) 10, which is a storage device and may be used as a main storage of an information processing apparatus (e.g., a host computer). The SSD 10 may be incorporated in the information processing apparatus or may be connected to the information processing apparatus via a cable or a network.

The computing device 20 may be an information processing apparatus (computing device). In some arrangements, the computer device 20 which is configured to handle or process data for training and perform a training a neural network (e.g., DNN 300), and the data for training may be collected from a plurality of SSDs by a plurality of computing devices. The data collected from the plurality of SSDs may be recorded and handled/processed by a different computing device, which is not necessarily connected to any of the SSDs and which performs the training based on the collected data. The computing device 20 includes a processor 21 and/or a database system 26. The database system 26 may store read thresholds values including training sets or results of a training.

The SSD 10 includes, for example, a controller 1420 and a flash memory 1480 as non-volatile memory (e.g., a NAND type flash memory). The SSD 10 may include a random access memory which is a volatile memory, for example, DRAM (Dynamic Random Access Memory) 1410 and/or SRAM (Static Random Access Memory) 1415. The random access memory has, for example, a read buffer which is a buffer area for temporarily storing data read out from the flash memory 1480, a write buffer which is a buffer area for temporarily storing data written in the flash memory 1480, and a buffer used for a garbage collection. In some arrangements, the controller 1420 may include DRAM or SRAM.

In some arrangements, the flash memory 1480 may include a memory cell array which includes a plurality of flash memory blocks (e.g., NAND blocks) 1482-1 to 1482-m. Each of the blocks 1482-1 to 1482-m may function as an erase unit. Each of the blocks 1482-1 to 1482-m includes a plurality of physical pages. In some arrangements, in the flash memory 1480, data reading and data writing are executed on a page basis, and data erasing is executed on a block basis.

In some arrangements, the controller 1420 may be a memory controller configured to control the flash memory 1480. The controller 1420 includes, for example, a processor (e.g., CPU) 1426, a flash memory interface 1428, and a memory interface 1422, a network interface 1424, all of which may be interconnected via a bus 1428. The memory interface 1422 may include a DRAM controller configured to control an access to the DRAM 1410, and a SRAM controller configured to control an access to the SRAM 1415. The flash memory interface 1428 may function as a flash memory control circuit (e.g., NAND control circuit) configured to control the flash memory 1480 (e.g., NAND type flash memory). The network interface 1424 may function as a circuit which receives various data from the computing device 20 and transmits data to the computing device 20. The data may include a plurality of sets of read thresholds or other data collected from the flash memory 1480 or a plurality of SSDs for training a neural network (e.g., DNN 300).

The controller 1420 may include a read circuit 1430, a programming circuit (e.g. a program DSP) 1440, and/or a programming parameter adapter 1450. As shown in FIG. 14, the adapter 1450 can adapt the programming parameters 1444 used by programming circuit 1440 as described above. The adapter 1450 in this example may include a Program/Erase (P/E) cycle counter 1452. Although shown separately for ease of illustration, some or all of the adapter 1450 can be incorporated in the programming circuit 1440. In some arrangements, the read circuit 230 may include an ECC decoder 1432 and threshold estimators (e.g., DNN-based R2R estimator, DNN-based FPQT estimator). In some arrangements, the programming circuit 1440 may include an ECC encoder 1442. Arrangements of memory controller 1420 can include additional or fewer components such as those shown in FIG. 14.

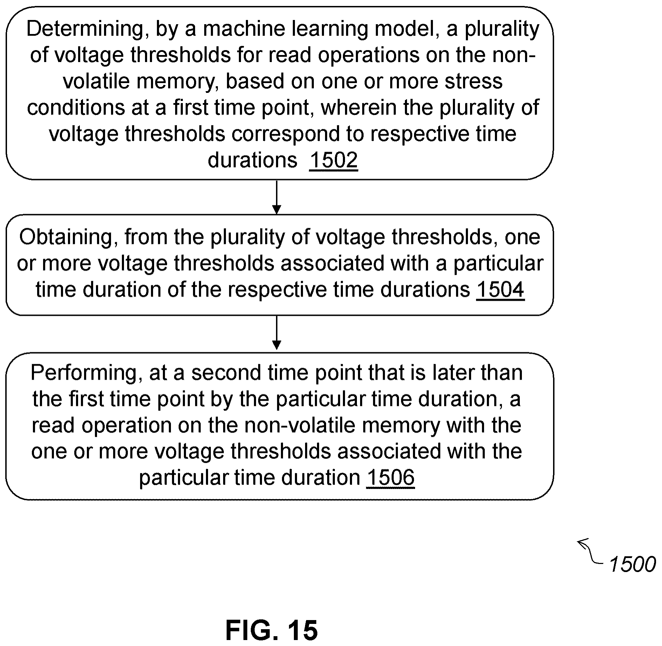

FIG. 15 is a flowchart illustrating an example methodology for dynamically adapting read thresholds based on per row optimal thresholds characterization, according to some arrangements. In some arrangements, the example methodology relates to a process 1500 executed or performed by a flash memory system (e.g., flash memory system 1400) or a circuit of the flash memory system (e.g., read circuit 1430, programming circuit 1440, programming parameter adapter 1450). The flash memory system may include a non-volatile memory (e.g., flash memory 1480). The non-volatile memory may include one or more blocks (e.g., blocks 1482-1, ..., 1482-m), each block including a plurality of rows of cells.

In this example, the process 1500 begins in step S1502 by the circuit determining, by a machine learning model (e.g., DNN 300) at a first time point (e.g., 1pm), a plurality of voltage thresholds (e.g., FP thresholds 554) for read operations on the non-volatile memory, based on one or more stress conditions at the first time point (e.g., Bake0p5H_55C in FIG. 7A at 1pm). The plurality of voltage thresholds (e.g., voltage thresholds for Bake6H_55C) may correspond to respective time durations since the first time point (e.g., 5.5 hours since 1pm). In some arrangements, the one or more stress conditions may include at least one of read disturb, data retention loss, temperature variations, mechanical stress, or error rate stress.

In some arrangements, the plurality of voltage thresholds may include at least one of voltage thresholds used for mock reads, voltage thresholds as a result of mock reads, or voltage thresholds used for reads of a particular page.

In step S1504, in some arrangements, the circuit may obtain, from the plurality of voltage thresholds, one or more voltage thresholds associated with a particular time duration (e.g., 5.5 hours) of the respective time durations.

In step S1506, in some arrangements, the circuit may perform, at a second time point (e.g., 6:30pm) that is later than the first time point (e.g., 1pm) by the particular time duration (e.g., 5.5 hours), a read operation on the non-volatile memory with the one or more voltage thresholds associated with the particular time duration.

In some arrangements, in determining the plurality of voltage thresholds, the circuit may be configured to obtain a first set of voltage thresholds for respective stress conditions associated with different time durations (e.g., for the stress condition Bake0p5H_55C in the second row in FIG. 7A, obtaining voltage thresholds corresponding to Bake0p5H_55C, Bake1H_55C, Bake2H_55C, ..., Bake30H_55C). The circuit may be configured to select, as a voltage threshold for a stress condition associated with the particular time duration, one voltage threshold (e.g., voltage thresholds for Bake6H_55C) from the first set of voltage thresholds.

In some arrangements, in selecting the one voltage threshold, the circuit may be configured to determine, among the first set of voltage thresholds, a second set of voltage thresholds associated with a plurality of bit error rates (BERs) that are less than a threshold BER (e.g., for the stress condition Bake0p5H_55C in the second row in FIG. 7A, the second set of voltage thresholds for Bake0p5H_55C, Bake1H_55C, Bake2H_55C, ..., Bake6H_55C whose BERs are less than 0.007), each of the plurality of BERs being measured when performing a read operation with a corresponding voltage threshold of the second set of voltage thresholds under the stress condition associated with the particular time duration. The circuit may be configured to determine, as the voltage threshold for the stress condition associated with the particular time duration, a voltage threshold associated with a largest BER among the second set of voltage thresholds (e.g., BER 711 is a largest BER (0.0054) among Bake0p5H_55C, Bake1H_55C, Bake2H_55C, ..., Bake6H_55C).

In some arrangements, in determining the plurality of voltage thresholds, the circuit may be configured to obtain one or more voltage thresholds for a first stress condition associated with a first time duration (e.g., DR of 1 month). The circuit may be configured to obtain one or more voltage thresholds for a second stress condition associated with a second time duration that is larger than the first time duration (e.g., DR of 1 year). The circuit may be configured to determine one or more voltage thresholds (e.g., perform database augmentation) for one or more stress conditions associated with one or more time durations (e.g., DR of 1, 2, 3, ..., 12 months) that are larger than the first time duration and smaller than the second time duration.

In some arrangements, in determining the plurality of voltage thresholds, the circuit may be configured to periodically perform a periodic read operation (e.g., patrol read process 1000 in FIG. 10) during an idle period on the non-volatile memory. In response to performing the periodic read operation, the circuit may be configured to determine, by the machine learning model, the plurality of voltage thresholds (e.g., FP voltage thresholds) for read operations, based on a result of the periodic read operation.

In some arrangements, the circuit may configured to store a plurality of voltage thresholds for each of a plurality of rows of cells. The non-volatile memory may include one or more blocks, each block including the plurality of rows of cells. The circuit may configured to update, at the second time point, the plurality of voltage thresholds for each row with the one or more voltage thresholds associated with the particular time duration (e.g., updating a history table with the estimated FP voltage thresholds in steps 514, 516 in FIG. 5A).

In some arrangements, the circuit may be configured to store, in a look-up table, the plurality of voltage thresholds for each row. The circuit may be configured to update, at the second time point, the look-up table with the one or more voltage thresholds associated with the particular time duration (e.g., updating a history table with the estimated FP voltage thresholds in steps 514, 516 in FIG. 5A). In performing the read operation on the non-volatile memory, the circuit may be configured to obtain a row identifier identifying a row of a target page, among the plurality of rows. The circuit may be configured to identify, using the updated look-up table, a third set of voltage thresholds for the read operation, based on the row identifier. The circuit may be configured to perform the read operation on the target page of the non-volatile memory with the third set of voltage thresholds.

In some arrangements, in determining the plurality of voltage thresholds, the circuit may be configured to perform one or more read operations on a target row of the plurality of rows of cells. The circuit may be configured to receive as input to the machine learning model (e.g., DNN estimator in step 1205 in FIG. 12), one or more features and a result of the one or more read operations. The circuit may be configured to determine as output of the machine learning model, the plurality of voltage thresholds (e.g., FP thresholds 1253). The one or more features may include an index corresponding to a subset of the one or more stress conditions, a row index identifying a row, a read temperature, or a program temperature. The result of the further read operation may include a histogram calculated based on states of the one or more read operations (e.g., histogram 1252).

In some arrangements, in determining the plurality of voltage thresholds, the circuit may be configured to perform inter-cell-interference (ICI) read operations on one or more rows of neighboring cells (e.g., step 1301 in the ICI compensation process 1300). The circuit may be configured to perform single state read operations on a target row of the plurality of rows of cells (e.g., step 1303). The circuit may be configured to receive as input to the machine learning model, results of the ICI read operations and the single state read operations. The circuit may be configured to determine as output of the machine learning model, the plurality of voltage thresholds (e.g., step 1305). The results of the ICI read operations and the single state read operations may include a joint histogram (e.g., histogram H 1351) of states of the ICI read operations and the single state read operations.

The previous description is provided to enable any person skilled in the art to practice the various aspects described herein. Various modifications to these aspects will be readily apparent to those skilled in the art, and the generic principles defined herein may be applied to other aspects. Thus, the claims are not intended to be limited to the aspects shown herein, but is to be accorded the full scope consistent with the language claims, wherein reference to an element in the singular is not intended to mean "one and only one" unless specifically so stated, but rather "one or more." Unless specifically stated otherwise, the term "some" refers to one or more. All structural and functional equivalents to the elements of the various aspects described throughout the previous description that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed as a means plus function unless the element is expressly recited using the phrase "means for."

It is understood that the specific order or hierarchy of steps in the processes disclosed is an example of illustrative approaches. Based upon design preferences, it is understood that the specific order or hierarchy of steps in the processes may be rearranged while remaining within the scope of the previous description. The accompanying method claims present elements of the various steps in a sample order, and are not meant to be limited to the specific order or hierarchy presented.

The previous description of the disclosed implementations is provided to enable any person skilled in the art to make or use the disclosed subject matter. Various modifications to these implementations will be readily apparent to those skilled in the art, and the generic principles defined herein may be applied to other implementations without departing from the spirit or scope of the previous description. Thus, the previous description is not intended to be limited to the implementations shown herein but is to be accorded the widest scope consistent with the principles and novel features disclosed herein.

The various examples illustrated and described are provided merely as examples to illustrate various features of the claims. However, features shown and described with respect to any given example are not necessarily limited to the associated example and may be used or combined with other examples that are shown and described. Further, the claims are not intended to be limited by any one example.

The foregoing method descriptions and the process flow diagrams are provided merely as illustrative examples and are not intended to require or imply that the steps of various examples must be performed in the order presented. As will be appreciated by one of skill in the art the order of steps in the foregoing examples may be performed in any order. Words such as "thereafter," "then," "next," etc. are not intended to limit the order of the steps; these words are simply used to guide the reader through the description of the methods. Further, any reference to claim elements in the singular, for example, using the articles "a," "an" or "the" is not to be construed as limiting the element to the singular.

The various illustrative logical blocks, modules, circuits, and algorithm steps described in connection with the examples disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The hardware used to implement the various illustrative logics, logical blocks, modules, and circuits described in connection with the examples disclosed herein may be implemented or performed with a general purpose processor, a DSP, an ASIC, an FPGA or other programmable logic device, discrete gate or transistor logic, discrete hardware components, or any combination thereof designed to perform the functions described herein. A general-purpose processor may be a microprocessor, but, in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration. Alternatively, some steps or methods may be performed by circuitry that is specific to a given function.

In some exemplary examples, the functions described may be implemented in hardware, software, firmware, or any combination thereof. If implemented in software, the functions may be stored as one or more instructions or code on a non-transitory computer-readable storage medium or non-transitory processor-readable storage medium. The steps of a method or algorithm disclosed herein may be embodied in a processor-executable software module which may reside on a non-transitory computer-readable or processor-readable storage medium. Non-transitory computer-readable or processor-readable storage media may be any storage media that may be accessed by a computer or a processor. By way of example but not limitation, such non-transitory computer-readable or processor-readable storage media may include RAM, ROM, EEPROM, FLASH memory, CD-ROM or other optical disk storage, magnetic disk storage or other magnetic storage devices, or any other medium that may be used to store desired program code in the form of instructions or data structures and that may be accessed by a computer. Disk and disc, as used herein, includes compact disc (CD), laser disc, optical disc, digital versatile disc (DVD), floppy disk, and blu-ray disc where disks usually reproduce data magnetically, while discs reproduce data optically with lasers. Combinations of the above are also included within the scope of non-transitory computer-readable and processor-readable media. Additionally, the operations of a method or algorithm may reside as one or any combination or set of codes and/or instructions on a non-transitory processor-readable storage medium and/or computer-readable storage medium, which may be incorporated into a computer program product.

The preceding description of the disclosed examples is provided to enable any person skilled in the art to make or use the present disclosure. Various modifications to these examples will be readily apparent to those skilled in the art, and the generic principles defined herein may be applied to some examples without departing from the spirit or scope of the disclosure. Thus, the present disclosure is not intended to be limited to the examples shown herein but is to be accorded the widest scope consistent with the following claims and the principles and novel features disclosed herein.

**Claims**

1. A flash memory system comprising:

   a non-volatile memory; and
   a circuit for performing operations on the non-volatile memory, the circuit being configured to:

      determine, by a machine learning model at a first time point, a plurality of voltage thresholds for read operations on the non-volatile memory, based on one or more stress conditions at the first time point, wherein the plurality of voltage thresholds correspond to respective time durations since the first time point;
      obtain, from the plurality of voltage thresholds, one or more voltage thresholds associated with a particular time duration of the respective time durations; and
      perform, at a second time point that is later than the first time point by the particular time duration, a read operation on the non-volatile memory with the one or more voltage thresholds associated with the particular time duration.

2. The flash memory system of claim 1, wherein the plurality of voltage thresholds may include at least one of voltage thresholds used for mock reads, voltage thresholds as a result of mock reads, or voltage thresholds used for reads of a particular page.

3. The flash memory system of claim 1, wherein in determining the plurality of voltage thresholds, the circuit is configured to:

   obtain a first set of voltage thresholds for respective stress conditions associated with different time durations; and
   select, as a voltage threshold for a stress condition associated with the particular time duration, one voltage threshold from the first set of voltage thresholds.

4. The flash memory system of claim 3, wherein in selecting the one voltage threshold, the circuit is configured to:

   determine, among the first set of voltage thresholds, a second set of voltage thresholds associated with a plurality of bit error rates (BERs) that are less than a threshold BER, each of the plurality of BERs being measured when performing a read operation with a corresponding voltage threshold of the second set of voltage thresholds under the stress condition associated with the particular time duration, and
   determine, as the voltage threshold for the stress condition associated with the particular time duration, a voltage threshold associated with a largest BER among the second set of voltage thresholds.

5. The flash memory system of claim 1, wherein in determining the plurality of voltage thresholds, the circuit is configured to:

   obtain one or more voltage thresholds for a first stress condition associated with a first time duration;

obtain one or more voltage thresholds for a second stress condition associated with a second time duration that is larger than the first time duration; and

determine one or more voltage thresholds for one or more stress conditions associated with one or more time durations that are larger than the first time duration and smaller than the second time duration.

6. The flash memory system of claim 1, wherein in determining the plurality of voltage thresholds, the circuit is configured to:

periodically perform a periodic read operation during an idle period on the non-volatile memory; and

in response to performing the periodic read operation, determine, by the machine learning model, the plurality of voltage thresholds for read operations, based on a result of the periodic read operation.

7. The flash memory system of claim 1, wherein the circuit is configured to:

store a plurality of voltage thresholds for each of a plurality of rows of cells, wherein the non-volatile memory comprises one or more blocks, each block comprising the plurality of rows of cells; and

at the second time point, update the plurality of voltage thresholds for each row with the one or more voltage thresholds associated with the particular time duration.

8. The flash memory system of claim 7, wherein

the circuit is configured to:

store, in a look-up table, the plurality of voltage thresholds for each row; and

at the second time point, update the look-up table with the one or more voltage thresholds associated with the particular time duration, and

in performing the read operation on the non-volatile memory, the circuit is configured to:

obtain a row identifier identifying a row of a target page, among the plurality of rows;

identify, using the updated look-up table, a third set of voltage thresholds for the read operation, based on the row identifier; and

perform the read operation on the target page of the non-volatile memory with the third set of voltage thresholds.

9. The flash memory system of claim 7, wherein in determining the plurality of voltage thresholds, the circuit is configured to:

perform one or more read operations on a target row of the plurality of rows of cells;

receive as input to the machine learning model, one or more features and a result of the one or more read operations; and

determine as output of the machine learning model, the plurality of voltage thresholds, wherein

the one or more features comprise an index corresponding to a subset of the one or more stress conditions, a row index identifying a row, a read temperature, or a program temperature, and

the result of the further read operation comprises a histogram calculated based on states of the one or more read operations.

10. The flash memory system of claim 1, wherein in determining the plurality of voltage thresholds, the circuit is configured to:

perform inter-cell-interference (ICI) read operations on one or more rows of neighboring cells;

perform single state read operations on a target row of the plurality of rows of cells;

receive as input to the machine learning model, results of the ICI read operations and the single state read operations; and

determine as output of the machine learning model, the plurality of voltage thresholds, wherein

the results of the ICI read operations and the single state read operations comprise a joint histogram of states of the ICI read operations and the single state read operations.

**11.** A method for performing operations on a non-volatile memory, comprising:

determining, by a machine learning model at a first time, a plurality of voltage thresholds for read operations on the non-volatile memory, based on one or more stress conditions at the first time point, wherein the plurality of voltage thresholds correspond to respective time durations since the first time point;

obtaining, from the plurality of voltage thresholds, one or more voltage thresholds associated with a particular time duration of the respective time durations; and

performing, at a second time point that is later than the first time point by the particular time duration, a read operation on the non-volatile memory with the one or more voltage thresholds associated with the particular time duration.

**12.** The method of claim 11, wherein the plurality of voltage thresholds may include at least one of voltage thresholds used for mock reads, voltage thresholds as a result of mock reads, or voltage thresholds used for reads of a particular page.

**13.** The method of claim 11, wherein determining the plurality of voltage thresholds comprises:

obtaining a first set of voltage thresholds for respective stress conditions associated with different time durations; and

selecting, as a voltage threshold for a stress condition associated with the particular time duration, one voltage threshold from the first set of voltage thresholds.

**14.** The method of claim 13, wherein selecting the one voltage threshold comprises:

determining, among the first set of voltage thresholds, a second set of voltage thresholds associated with a plurality of bit error rates (BERs) that are less than a threshold BER, each of the plurality of BERs being measured when performing a read operation with a corresponding voltage threshold of the second set of voltage thresholds under the stress condition associated with the particular time duration, and

determining, as the voltage threshold for the stress condition associated with the particular time duration, a voltage threshold associated with a largest BER among the second set of voltage thresholds.

**15.** The method of claim 11, wherein determining the plurality of voltage thresholds comprises:

obtaining one or more voltage thresholds for a first stress condition associated with a first time duration; obtaining one or more voltage thresholds for a second stress condition associated with a second time duration that is larger than the first time duration; and

determining one or more voltage thresholds for one or more stress conditions associated with one or more time durations that are larger than the first time duration and smaller than the second time duration.

**16.** The method of claim 11, wherein determining the plurality of voltage thresholds comprises:

periodically performing a periodic read operation during an idle period on the non-volatile memory; and

in response to performing the periodic read operation, determining, by the machine learning model, the plurality of voltage thresholds for read operations, based on a result of the periodic read operation.

**17.** The method of claim 11, further comprising:

storing a plurality of voltage thresholds for each of a plurality of rows of cells, wherein the non-volatile memory comprises one or more blocks, each block comprising the plurality of rows of cells; and

at the second time point, updating the plurality of voltage thresholds for each row with the one or more voltage thresholds associated with the particular time duration.

**18.** The method of claim 17, wherein

the plurality of voltage thresholds for each row are stored in a look-up table,

at the second time point, the look-up table is updated with the one or more voltage thresholds associated with the particular time duration, and

performing the read operation on the non-volatile memory comprises:

obtaining a row identifier identifying a row of a target page, among the plurality of rows;

identifying, using the updated look-up table, a third set of voltage thresholds for the read operation, based on the row identifier; and

performing the read operation on the target page of the non-volatile memory with the third set of voltage thresholds.

19. The method of claim 17, wherein determining the plurality of voltage thresholds comprises:

performing one or more read operations on a target row of the plurality of rows of cells;

receiving as input to the machine learning model, one or more features and a result of the one or more read operations; and

determining as output of the machine learning model, the plurality of voltage thresholds, wherein

the one or more features comprise an index corresponding to a subset of the one or more stress conditions, a row index identifying a row, a read temperature, or a program temperature, and

the result of the further read operation comprises a histogram calculated based on states of the one or more read operations.

20. The method of claim 11, wherein determining the plurality of voltage thresholds comprises:

performing inter-cell-interference (ICI) read operations on one or more rows of neighboring cells;

performing single state read operations on a target row of the plurality of rows of cells;

receiving as input to the machine learning model, results of the ICI read operations and the single state read operations; and

determining as output of the machine learning model, the plurality of voltage thresholds, wherein

the results of the ICI read operations and the single state read operations comprise a joint histogram of states of the ICI read operations and the single state read operations.

100

| | T$_1$ | T$_2$ | T$_3$ | T$_4$ | T$_5$ | T$_6$ | T$_7$ | T$_8$ | T$_9$ | T$_{10}$ | T$_{11}$ | T$_{12}$ | T$_{13}$ | T$_{14}$ | T$_{15}$ |

|  | 0 | 1 | 2 | 3 | 4 | 5 | 6 | 7 | 0 | 1 | 2 | 3 | 4 | 5 | 6 | 7 |
|---|---|---|---|---|---|---|---|---|---|---|---|---|---|---|---|---|
| Top page | 1 | 1 | 1 | 1 | 1 | 0 | 0 | 1 | 1 | 0 | 0 | 0 | 0 | 0 | 0 | 1 |
| Upper page | 1 | 1 | 1 | 0 | 0 | 0 | 0 | 0 | 0 | 0 | 0 | 1 | 1 | 1 | 0 | 0 |
| Middle page | 1 | 1 | 0 | 0 | 0 | 0 | 0 | 0 | 1 | 1 | 0 | 0 | 0 | 1 | 1 | 1 |
| Lower page | 1 | 0 | 0 | 1 | 1 | 1 | 0 | 0 | 0 | 0 | 0 | 0 | 1 | 1 | 1 | 1 |

V

FIG. 1

202 — First Phase Read

204 — Decode HB

206 — Retry –fixed Thresholds Table + HB Decode

208 — Quick Threshold Tracking

210 — Decode HB

212 — Tracking Vth

214 — Sampling + Soft Decoding

200

**FIG. 2**

**FIG. 3**

FIG. 4A

EP 4 783 170 A1

FIG. 4B

EP 4 783 170 A1

Read next page _502_

_504_

HT-Get
(HTIndex)

R2R

_508_

Normal Read — _506_

Decode HB — _520_

R2R

_510_

Shift Table + HB Decode

_512_

Future Predictive Quick
Threshold Tracking Estimation

_522_

Current
Thresholds _552_

Future Predictive
Thresholds _554_

Decode HB

_524_

HT-Set and R2R

_514_

Update
HTIndex

_516_

Tracking Vth

_526_

Sampling + Soft Decoding

_528_

_500_

**FIG. 5A**

**FIG. 5B**

Create database of voltage thresholds (VT) distribution that contains all stresses that need to be supported by VT-tracking estimator — 601

Compute optimal thresholds for all rows in database, which serve as labels for training and evaluation — 602

For stress that is considered with forward prediction, e.g., data retention (DR): evaluate, for a given stress, optimal thresholds, and use these thresholds (on corresponding rows) to be evaluated on all lower stress according to their stress strength. E.g., for DR1, use optimal thresholds of DR1 to evaluate fail bit counts (FBC) with optimal thresholds of DR1 on shorter time retention cases. — 603

For all stresses that have optimal thresholds 100PPM BER below BER_TH, select lower stress for mapping as the lowest stress that has 100 PPM BER below the same BER_TH — 604

Define optimal thresholds labels for database rows according to above conditions for the forward predictive stresses. For other stresses for which no forward prediction is applied use current optimal thresholds. — 605

Database ready for training — 606

600

## FIG. 6

EP 4 783 170 A1

EP 4 783 170 A1

| | R0 | Bake0p5H_55C | Bake1H_55C | Bake2H_55C | Bake3H_55C | Bake4H_55C | Bake6H_55C | Bake8H_55C | Bake9H_55C | Bake12H_55C | Bake18H_55C | Bake24H_55C | Bake30H_55C |
|---|---|---|---|---|---|---|---|---|---|---|---|---|---|
| | | | | | | | Thresholds from stresses 701 | | | | | | |
| R0 | 0.0027 | 0.0037 | 0.0032 | 0.0029 | 0.0029 | 0.0029 | 0.0029 | 0.0031 | 0.0032 | 0.0034 | 0.0040 | 0.0048 | 0.0057 |
| Bake0p5H_55C | 0.0035 | 0.0017 | 0.0017 | 0.0020 | 0.0026 | 0.0033 | 0.0054 | 0.0074 | 0.0089 | 0.0119 | 0.0190 | 0.0259 | 0.0334 |
| Bake1H_55C | 0.0030 | 0.0023 | 0.0023 | 0.0023 | 0.0025 | 0.0027 | 0.0034 | 0.0044 | 0.0050 | 0.0066 | 0.0103 | 0.0140 | 0.0181 |
| Bake2H_55C | 0.0033 | 0.0035 | 0.0031 | 0.0030 | 0.0030 | 0.0031 | 0.0033 | 0.0036 | 0.0038 | 0.0045 | 0.0062 | 0.0081 | 0.0104 |
| Bake3H_55C | 0.0038 | 0.0046 | 0.0038 | 0.0036 | 0.0035 | 0.0035 | 0.0037 | 0.0038 | 0.0039 | 0.0042 | 0.0052 | 0.0063 | 0.0078 |
| Bake4H_55C | 0.0043 | 0.0057 | 0.0045 | 0.0041 | 0.0040 | 0.0040 | 0.0040 | 0.0041 | 0.0042 | 0.0044 | 0.0050 | 0.0058 | 0.0067 |
| Bake6H_55C | 0.0052 | 0.0079 | 0.0059 | 0.0050 | 0.0048 | 0.0047 | 0.0046 | 0.0047 | 0.0047 | 0.0048 | 0.0051 | 0.0055 | 0.0060 |
| Bake8H_55C | 0.0061 | 0.0101 | 0.0072 | 0.0059 | 0.0055 | 0.0053 | 0.0052 | 0.0052 | 0.0052 | 0.0052 | 0.0054 | 0.0057 | 0.0060 |
| Bake9H_55C | 0.0066 | 0.0111 | 0.0078 | 0.0063 | 0.0059 | 0.0056 | 0.0055 | 0.0054 | 0.0054 | 0.0054 | 0.0056 | 0.0058 | 0.0061 |
| Bake12H_55C | 0.0079 | 0.0142 | 0.0097 | 0.0075 | 0.0069 | 0.0066 | 0.0062 | 0.0061 | 0.0061 | 0.0060 | 0.0061 | 0.0062 | 0.0064 |
| Bake18H_55C | 0.0102 | 0.0199 | 0.0133 | 0.0097 | 0.0087 | 0.0082 | 0.0076 | 0.0074 | 0.0073 | 0.0071 | 0.0070 | 0.0071 | 0.0072 |
| Bake24H_55C | 0.0123 | 0.0249 | 0.0168 | 0.0118 | 0.0103 | 0.0096 | 0.0088 | 0.0084 | 0.0083 | 0.0081 | 0.0079 | 0.0078 | 0.0079 |
| Bake30H_55C | 0.0142 | 0.0293 | 0.0200 | 0.0137 | 0.0117 | 0.0109 | 0.0099 | 0.0095 | 0.0093 | 0.0090 | 0.0086 | 0.0085 | 0.0085 |

Data from stresses 702

700

**FIG. 7A**

Estimated thresholds 780

| R0 (col 1) |
| Bake0p5H55C (col 2) |
| Bake1H55C (col 3) |
| Bake2H55C (col 4) |
| Bake3H55C (col 5) |
| Bake4H55C (col 6) |
| Bake6H55C (col 7) |
| Bake8H55C (col 8) |
| Bake9H55C (col 9) |
| Bake12H55C (col 10) |
| Bake18H55C (col 11) |
| Bake24H55C (col 12) |
| Bake30H55C (col 13) |

Mock reads 760

| R0 (row 1) |
| Bake0p5H55C (row 2) |
| Bake1H55C (row 3) |
| Bake2H55C (row 4) |
| Bake3H55C (row 5) |
| Bake4H55C (row 6) |
| Bake6H55C (row 7) |
| Bake8H55C (row 8) |
| Bake9H55C (row 9) |
| Bake12H55C (row 10) |
| Bake18H55C (row 11) |
| Bake24H55C (row 12) |
| Bake30H55C (row 13) |

QT
PFQT
PFQT
PFQT
PFQT
QT
QT
QT
QT
QT

750

FIG. 7B

```
┌─────────────────────────────────────────────────────────────────────┐
│ Create database of voltage thresholds (VT) distribution that contains │ ─ 801
│          all stresses that need to be supported by VT-tracking        │
│                              estimator                                │
└─────────────────────────────────────────────────────────────────────┘
                                   │
                                   ▼
┌─────────────────────────────────────────────────────────────────────┐
│ Define a stress range for which refined data for future thresholds    │ ─ 802
│ prediction is required, and perform database augmentation to obtain    │
│ a fine resolution of stress conditions for forward reference selection │
│                              on training                              │
└─────────────────────────────────────────────────────────────────────┘
                                   │
                                   ▼
┌─────────────────────────────────────────────────────────────────────┐
│ Compute optimal thresholds for all rows in database, which serve as   │ ─ 803
│                  labels for training and evaluation                   │
└─────────────────────────────────────────────────────────────────────┘
                                   │
                                   ▼
┌─────────────────────────────────────────────────────────────────────┐
│ For stress that is considered with forward prediction, e.g., data     │ ─ 804
│ retention (DR): evaluate, for a given stress, optimal thresholds, and  │
│ use these thresholds (on corresponding rows) to be evaluated on all    │
│ lower stress according to their stress strength. E.g., for DR1, use    │
│ optimal thresholds of DR1 to evaluate fail bit counts (FBC) with       │
│ optimal thresholds of DR1 on shorter time retention cases.             │
└─────────────────────────────────────────────────────────────────────┘
                                   │
                                   ▼
┌─────────────────────────────────────────────────────────────────────┐
│ For all stresses that have optimal thresholds 100PPM BER below         │ ─ 805
│ BER_TH, select lower stress for mapping as the lowest stress that has  │
│           100 PPM BER below the same BER_TH                           │
└─────────────────────────────────────────────────────────────────────┘
                                   │
                                   ▼
┌─────────────────────────────────────────────────────────────────────┐
│ Define optimal thresholds labels for database rows according to above  │ ─ 806
│ conditions for the forward predictive stresses. For other stresses for │
│ which no forward prediction is applied use current optimal thresholds. │
└─────────────────────────────────────────────────────────────────────┘
                                   │
                                   ▼
┌─────────────────────────────────────────────────────────────────────┐
│                    Database ready for training                        │ ─ 807
└─────────────────────────────────────────────────────────────────────┘
                                                                      ─ 800
```

**FIG. 8**

EP 4 783 170 A1

Start patrol read for **every T hours** — 901

Controller holds and maintains a list of written blocks per die that require thresholds refresh — 902

Examine all dies and blocks for patrol, and for each perform the following steps — 903

For all available dies (no other higher priority read/ write operations) determine next block and send thresholds-tracking command — 904

Perform N mock single state reads with predetermined threshold, from target row — 905

Compute a histogram of VT-distribution from all single state reads — 906

$\underline{H}$ — 951

Estimate target row **current** thresholds from histogram $\underline{H}$ using a LUT/linear/ DNN estimator Estimate also High/Low BER (classification) — 907

952 — Th        BERStatus — 953

HT-Set for target block — 908

Done thresholds-tracking for scheduled dies/blocks? — 909

No

Yes

Patrol Done — 911

Continue to next block — 910

BERStatus 953

900

**FIG. 9**

Start patrol read for every **U (>T) hours (e.g., 2T hours)** ⟋ 1001

Controller holds and maintains a list of written blocks per die that require thresholds refresh ⟋ 1002

Examine all dies and blocks for patrol, and for each perform the following steps ⟋ 1003

For all available dies (no other higher priority read/ write operations) determine next block and send thresholds-tracking command ⟋ 1004

Perform N mock single state reads with predetermined threshold, from target row ⟋ 1005

Compute a histogram of VT distribution from all single state reads ⟋ 1006

H ⟋ 1051

Estimate target row **future** thresholds from histogram H using a LUT/linear/DNN estimator Estimate also High/Low BER (classification) ⟋ 1007

1052 ⟋ Th        BERStatus ⟋ 1053

HT-Set for target block ⟋ 1008

Done thresholds-tracking for scheduled dies/blocks? ⟋ 1009

No

Continue to next block

1010 ⟋

BERStatus

1053 ⟋

Yes

Patrol Done ⟋ 1011

⟋ 1000

**FIG. 10**

FIG. 11

**FIG. 12**

Start threshold tracking with current read — 1201

Keep an existing current read result (obtained during previous retry state), and determine additional page types to read — 1202

Additional Pg types — 1251

Perform additional page reads for target row on additional pg types, in predetermined mock locations — 1203

Compute a histogram of all single state reads — 1204

H — 1252

DNN estimator of future thresholds using all features input — 1205

FPThresholds — 1253

CurrThresholds — 1254

HT-Set for target block — 1206

Current Read — 1207

1200

Dynamic ICI page read from NAND without decoding — 1301

Read neighbor row in a predetermined fixed threshold into an internal buffer. This is interference source, e.g. WL(n+1) — 1302

Perform N mock single state reads with predetermined threshold, from target row — 1303

Compute a joint histogram of ICI reads and single state reads — 1304

H — 1351

Estimate FUTURE target page read thresholds from histogram H using LUT/linear/DNN estimator — 1305

Read target page using the estimated thresholds according to number of ICI states — 1306

Select per ICI state of page data according to its corresponding thresholds read result – this is the ICI compensation — 1307

1300

FIG. 13

**FIG. 14**

EP 4 783 170 A1

Determining, by a machine learning model, a plurality of voltage thresholds for read operations on the non-volatile memory, based on one or more stress conditions at a first time point, wherein the plurality of voltage thresholds correspond to respective time durations  1502

Obtaining, from the plurality of voltage thresholds, one or more voltage thresholds associated with a particular time duration of the respective time durations 1504

Performing, at a second time point that is later than the first time point by the particular time duration, a read operation on the non-volatile memory with the one or more voltage thresholds associated with the particular time duration 1506

1500

**FIG. 15**

EP 4 783 170 A1

Europäisches
Patentamt

European
Patent Office

Office européen
des brevets

# EUROPEAN SEARCH REPORT

**Application Number**

EP 26 15 2687

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/057711 A1 (STEINER AVI [IL] ET AL) 23 February 2023 (2023-02-23) * [0080]-[0081], [0084], [0115]; figures 1,5,9 * | 1-20 | INV. G11C11/56 G11C16/26 G11C16/34 G11C29/02 |
| A | US 2023/055823 A1 (STEINER AVI [IL] ET AL) 23 February 2023 (2023-02-23) * figures 6,7 * | 1-20 | ADD. G11C16/04 |
| A | US 2024/312528 A1 (NITZAN EYAL [IL] ET AL) 19 September 2024 (2024-09-19) * figure 3 * | 1-20 | |

**TECHNICAL FIELDS SEARCHED (IPC)**

G11C

The present search report has been drawn up for all claims

| Place of search | Date of completion of the search | Examiner |
|---|---|---|
| The Hague | 5 June 2026 | Kearey, Robin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 26 15 2687

This annex lists the patent family members relating to the patent documents cited in the above-mentioned European search report.
The members are as contained in the European Patent Office EDP file on
The European Patent Office is in no way liable for these particulars which are merely given for the purpose of information.

05-06-2026

| Patent document cited in search report | | Publication date | Patent family member(s) | | Publication date |
|---|---|---|---|---|---|
| US 2023057711 | A1 | 23-02-2023 | CN | 115708157 A | 21-02-2023 |
| | | | TW | 202329115 A | 16-07-2023 |
| | | | US | 2023057711 A1 | 23-02-2023 |
| US 2023055823 | A1 | 23-02-2023 | CN | 115713956 A | 24-02-2023 |
| | | | TW | 202322134 A | 01-06-2023 |
| | | | US | 2023055823 A1 | 23-02-2023 |
| US 2024312528 | A1 | 19-09-2024 | NONE | | |

EPO FORM P0459

For more details about this annex : see Official Journal of the European Patent Office, No. 12/82